# EUROPÄISCHE PATENTSCHRIFT

(11) **EP 2 714 704 B1**
(45) Veröffentlichungstag und Bekanntmachung des Hinweises auf die Patenterteilung: **29.04.2015**
(21) Anmeldenummer: 12726734.2
(22) Anmeldetag: 10.05.2012
(51) Int. Cl.: C07F 15/00, C09K 11/00, H01L 51/00, H05B 33/00

(54) **METALLKOMPLEXE**
METAL COMPLEXES
COMPLEXES MÉTALLIQUES

(30) Priorität: 03.06.2011 EP 11004545
(43) Veröffentlichungstag der Anmeldung: 09.04.2014
(73) Patentinhaber: Merck Patent GmbH, 64293 Darmstadt (DE)
(72) Erfinder: STOESSEL, Philipp, 60487 Frankfurt am Main (DE); BREUNING, Esther, 64372 Ober-Ramstadt (DE)
(86) Internationale Anmeldenummer: PCT/EP2012/002013
(87) Internationale Veröffentlichungsnummer: WO 2012/163471

(56) Entgegenhaltungen:
- EP-A1- 2 113 548
- EP-A2- 1 683 804
- MASATO KURATSU ET AL: "Magnetic Interaction of Tri- and Di-oxytriphenylamine Radical Cation FeCl 4 Salts", INORGANIC CHEMISTRY, Bd. 46, Nr. 24, 1. November 2007 (2007-11-01), Seiten 10153-10157, XP55033662, ISSN: 0020-1669, DOI: 10.1021/ic7012649

## Beschreibung

Die vorliegende Erfindung betrifft Metallkomplexe, welche sich für den Einsatz als Emitter in organischen Elektrolumineszenzvorrichtungen eignen.

Der Aufbau organischer Elektrolumineszenzvorrichtungen (OLEDs), in denen organische Halbleiter als funktionelle Materialien eingesetzt werden, ist beispielsweise in US 4539507, US 5151629, EP 0676461 und WO 98/27136 beschrieben. Als emittierende Materialien werden häufig metallorganische Komplexe eingesetzt, die Phosphoreszenz statt Fluoreszenz zeigen (M. A. Baldo et al., Appl. Phys. Lett. 1999, 75, 4-6). Aus quantenmechanischen Gründen ist unter Verwendung metallorganischer Verbindungen als Phosphoreszenzemitter eine bis zu vierfache Energie- und Leistungseffizienz möglich. Generell gibt es bei OLEDs, die Triplettemission zeigen, immer noch Verbesserungsbedarf, insbesondere im Hinblick auf Effizienz, Betriebsspannung und Lebensdauer.

Gemäß dem Stand der Technik werden in phosphoreszierenden OLEDs als Triplettemitter insbesondere Iridium- oder Platinkomplexe eingesetzt. Eine Verbesserung der verwendeten Platinkomplexe kann erzielt werden, indem Metallkomplexe mit tetradentatem Liganden eingesetzt werden, wodurch die Komplexe eine höhere thermische Stabilität aufweisen (WO 2004/108857, WO 2005/042550, WO 2005/042444). Es besteht jedoch weiterer Verbesserungsbedarf bei Platinkomplexen, insbesondere in Bezug auf die thermische Stabilität, die Effizienz, die Lebensdauer und/oder die Betriebsspannung.

Aufgabe der vorliegenden Erfindung ist daher die Bereitstellung neuer Metallkomplexe, welche sich als Emitter für die Verwendung in OLEDs eignen.

Überraschend wurde gefunden, dass bestimmte, unten näher beschriebene Metallchelatkomplexe diese Aufgabe lösen und zu Verbesserungen der organischen Elektrolumineszenzvorrichtung führen. Weiterhin weisen diese Metallkomplexe eine hohe thermische Stabilität auf. Diese Metallkomplexe und organische Elektrolumineszenzvorrichtungen, welche diese Komplexe enthalten, sind daher der Gegenstand der vorliegenden Erfindung.

Gegenstand der Erfindung ist eine Verbindung gemäß Formel (1), 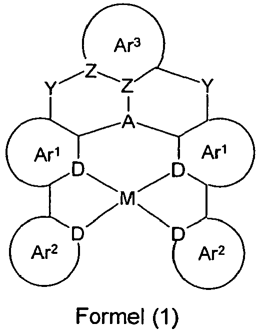 wobei für die verwendeten Symbole gilt:
- M: ist ein Übergangsmetall;
- A: ist N, P, B, C⁻ oder CR;
- Y: ist bei jedem Auftreten gleich oder verschieden CR₂, NR, O, S oder eine Einfachbindung, wobei maximal eine Gruppe Y für eine Einfachbindung steht;
- Z: ist bei jedem Auftreten gleich oder verschieden C oder N, mit der Maßgabe, dass beide Z für C stehen, wenn Ar³ für einen aromatischen oder heteroaromatischen Sechsring steht, und dass entweder beide Z für C stehen oder dass ein Z für C steht und das andere Z für N steht, wenn Ar³ für einen heteroaromatischen Fünfring steht;
- D: ist bei jedem Auftreten gleich oder verschieden C oder N;
- Ar¹: ist bei jedem Auftreten gleich oder verschieden zusammen mit der Gruppe D und den drei explizit eingezeichneten Kohlenstoffatomen eine Aryl- oder Heteroarylgruppe mit 5 bis 13 aromatischen Ringatomen, bevorzugt mit 5 bis 10 aromatischen Ringatomen, die jeweils durch einen oder mehrere Reste R¹ substituiert sein kann;
- Ar²: ist bei jedem Auftreten gleich oder verschieden zusammen mit der Gruppe D und dem explizit eingezeichneten Kohlenstoffatom eine Aryl- oder Heteroarylgruppe mit 5 bis 13 aromatischen Ringatomen, bevorzugt mit 5 bis 10 aromatischen Ringatomen, die jeweils durch einen oder mehrere Reste R¹ substituiert sein kann;
- Ar³: ist zusammen mit den beiden Gruppen Z und dem eingezeichneten Kohlenstoffatom eine Aryl- oder Heteroarylgruppe mit 5 bis 10 aromatischen Ringatomen, die durch einen oder mehrere Resten R¹ substituiert sein kann;
- R, R¹: ist bei jedem Auftreten gleich oder verschieden H, D, F, Cl, Br, I, N(R²)₂, CN, NO₂, OH, COOH, C(=O)N(R²)₂, Si(R²)₃, B(OR²)₂, C(=O)_{R}², P(=O)(R²)₂, S(=O)R², S(=O)₂R², OSO₂R², eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten R² substituiert sein kann, wobei eine oder mehrere nicht benachbarte CH₂-Gruppen durch R²C=CR², C≡C, Si(R²)₂, C=O, NR², O, S oder CONR² ersetzt sein können und wobei ein oder mehrere H-Atome durch D, F, Cl, Br, I oder CN ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 40 aromatischen Ringatomen, die durch einen oder mehrere Reste R² substituiert sein kann, oder eine Aralkyl- oder Heteroaralkylgruppe mit 5 bis 40 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann; dabei können zwei benachbarte Reste R oder zwei benachbarte Reste R¹ auch miteinander ein mono- oder polycyclisches, aliphatisches oder aromatisches Ringsystem bilden; weiterhin können auch die Reste R¹, die an benachbarte Gruppen Ar¹ und Ar² binden, miteinander ein mono- oder polycyclisches, aliphatisches oder aromatisches Ringsystem bilden;
- R²: ist bei jedem Auftreten gleich oder verschieden H, D, F, Cl, Br, I, N(R³)₂, CN, NO₂, Si(R³)ₛ, B(OR³)₂, C(=O)R³, P(=O)(R³)₂, S(=O)R³, S(=O)₂R3, OSO₂R³, eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten R³ substituiert sein kann, wobei eine oder mehrere nicht benachbarte CH₂-Gruppen durch R³C=CR³, C=C, Si(R³)₂, C=O, NR³, O, S oder CONR³ ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 40 aromatischen Ringatomen, die durch einen oder mehrere Reste R³ substituiert sein kann, oder eine Aralkyl- oder Heteroaralkylgruppe mit 5 bis 40 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann; dabei können zwei oder mehrere benachbarte Reste R³ miteinander ein mono- oder polycyclisches, aliphatisches Ringsystem bilden;
- R³: ist bei jedem Auftreten gleich oder verschieden H, D, F oder ein aliphatischer, aromatischer und/oder heteroaromatischer Kohlenwasserstoffrest mit 1 bis 20 C-Atomen, in dem auch ein oder mehrere H-Atome durch F ersetzt sein können; dabei können zwei oder mehrere Substituenten R³ auch miteinander ein mono- oder polycyclisches, aliphatisches Ringsystem bilden.

Dabei bedeutet in der Definition von Z "wenn Ar³ für einen aromatischen oder heteroaromatischen Sechsring steht", dass es sich bei dem Teil der Gruppe Ar³, der direkt an A und die beiden Gruppen Y bindet, um einen aromatischen oder heteroaromatischen Sechsring handelt. Entsprechend bedeutet in der Definition von Z "wenn Ar³ für einen heteroaromatischen Fünfring steht", dass es sich bei dem Teil der Gruppe Ar³, der direkt an A und die beiden Gruppen Y bindet, um einen heteroaromatischen Fünfring handelt. Selbstverständlich können an diesen Sechs- bzw. Fünfring noch andere aromatische oder heteroaromatische Gruppen ankondensiert sein, so dass eine größere kondensierte aromatische bzw. heteroaromatische Gruppe entsteht. Dies ist im Folgenden schematisch dargestellt, wobei jeweils die Bindung an Y und A mit dargestellt ist:

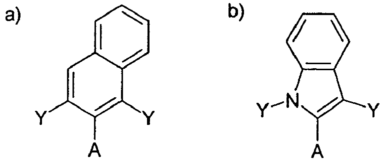

So ist im Sinne der vorliegenden Erfindung die unter a) dargestellte Struktur eine Struktur, in der Ar³ für einen aromatischen Sechsring steht, und die unter b) dargestellte Struktur eine Struktur, in der Ar³ für einen heteroaromatischen Fünfring steht.

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Ein aromatisches Ringsystem im Sinne dieser Erfindung enthält 6 bis 60 C-Atome im Ringsystem. Ein heteroaromatisches Ringsystem im Sinne dieser Erfindung enthält 1 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sollen Systeme, in denen zwei oder mehrere Aryl- oder Heteroarylgruppen direkt aneinander gebunden sind, wie z. B. Biphenyl oder Terphenyl, ebenfalls als aromatisches bzw. heteroaromatisches Ringsystem verstanden werden.

Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einer C₁- bis 6₄₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, tert-Pentyl, 2-Pentyl, neo-Pentyl, Cyclopentyl, n-Hexyl, s-Hexyl, tert-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Adamantyl, Trifluormethyl, Pentafluorethyl oder 2,2,2-Trifluorethyl verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer C₁- bis C₄₀-Alkoxy-gruppe werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Unter einem aromatischen oder heteroaromatischen Ringsystem mit 5 - 60 aromatischen Ringatomen, welches noch jeweils mit den oben genannten Resten R substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Indenocarbazol, cis- oder trans-Indolocarbazol, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Wie oben aufgeführt, können auch benachbarte Reste R bzw. benachbarte Reste R¹ bzw. Reste R¹ an benachbarten Aryl- bzw. Heteroarylgruppen Ar¹ und Ar² miteinander ein Ringsystem bilden. Unter benachbarten Resten im Sinne der vorliegenden Erfindung werden Reste verstanden, die entweder an dasselbe Atom gebunden sind, beispielsweise die Reste R, wenn die Gruppe Y für CR₂ steht, oder Reste, die an Atome gebunden sind, welche direkt aneinander gebunden sind. Unter benachbarten Aryl- bzw. Heteroarylgruppen Ar¹ und Ar² werden Aryl- bzw. Heteroarylgruppen Ar¹ und Ar² verstanden, die direkt aneinander gebunden sind. Dabei sind die Reste wie oben definiert, und zwei Reste binden jeweils unter formaler Abspaltung eines Wasserstoffatoms aneinander. Wenn es sich bei den Resten um Alkylgruppen handelt, ist so beispielsweise die Bildung einer ankondensierten Cycloalkylgruppe möglich. Wenn es sich bei den Resten um Vinylgruppen bzw. um eine Vinylgruppe und ein Wasserstoffatom handelt, ist so beispielsweise die Bildung einer kondensierten Arylgruppe möglich. Wenn die Reste R bzw. R¹ ein Ringsystem bilden, dann handelt es sich bevorzugt um einen Fünfring oder einen Sechsring.

Bevorzugt sind Verbindungen gemäß Formel (1), dadurch gekennzeichnet, dass diese nicht geladen, d. h. elektrisch neutral, sind. Dies wird auf einfache Weise dadurch erreicht, dass die Ladung des Liganden so gewählt wird, dass sie die Ladung des komplexierten Metallatoms M kompensiert. Die Ladung des Liganden ergibt sich aus der Anzahl der koordinierenden Kohlenstoffatome, welche jeweils eine negative Ladung aufweisen, und gegebenfalls durch die Gruppe A, wenn diese Gruppe für C⁻ steht.

Bevorzugt sind weiterhin Verbindungen gemäß Formel (1), dadurch gekennzeichnet, dass die Summe der Valenzelektronen um das Metallatom 16 beträgt.

Bevorzugt ist das Metall M ausgewählt aus der Gruppe bestehend aus Platin, Palladium, Nickel, Rhodium, Iridium und Gold. Besonders bevorzugt sind die oben genannten Metalle in den Oxidationsstufen Pt(II), Pd(II), Ni(II), Rh(I), Ir(I) und Au(III). Besonders bevorzugt sind Pt(II), Ir(I) und Au(III). Ganz besonders bevorzugt ist Pt(II).

Weiterhin bevorzugt stehen in der erfindungsgemäßen Verbindung zwei Gruppen D für N, und die anderen beiden Gruppen D stehen für C. Besonders bevorzugt stehen entweder beide Gruppen D in den Gruppen Ar¹ für N und beide Gruppen D in den Gruppen Ar² für C, oder es stehen beide Gruppen D in den Gruppen Ar¹ für C und beide Gruppen D in den Gruppen Ar² für N.

Weiterhin bevorzugt steht A für N oder P, besonders bevorzugt für N.

Besonders bevorzugt treten die oben genannten Bevorzugungen gleichzeitig auf und M ist Pt(II), entweder beide Gruppen D in den Gruppen Ar¹ stehen für N und beide Gruppen D in den Gruppen Ar² stehen für C, oder beide Gruppen D in den Gruppen Ar¹ stehen für C und beide Gruppen D in den Gruppen Ar² stehen für N und A steht für N.

Weiterhin bevorzugt steht Y gleich oder verschieden bei jedem Auftreten für CR₂ oder für eine Einfachbindung, wobei maximal eine Gruppe Y für eine Einfachbindung steht. Besonders bevorzugt steht Y gleich oder verschieden bei jedem Auftreten für CR₂.

In einer weiteren bevorzugten Ausführungsform der Erfindung sind beide Brücken Y gleich gewählt.

Bevorzugte Strukturen der Formel (1) sind daher die Strukturen der folgenden Formel (2), 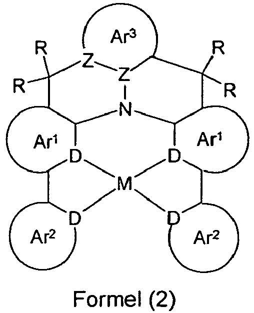 wobei die verwendeten Symbole die oben genannten Bedeutungen aufweisen.

In einer bevorzugten Ausführungsform der Erfindung ist Ar³ ausgewählt aus den Strukturen der folgenden Formeln (3), (4) und (5), 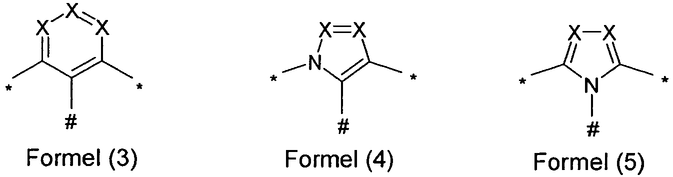 wobei X gleich oder verschieden bei jedem Auftreten für CR¹ oder N steht oder wobei zwei benachbarte Gruppen X in Formel (3) zusammen für NR, O oder S stehen und die andere Gruppe X für CR¹ oder N steht; * deutet die Bindung an Y an und # deutet die Bindung an A an. Besonders bevorzugte Gruppen Ar³ sind Strukturen der Formel (3).

In einer bevorzugten Ausführungsform der Strukturen gemäß Formel (3) bis (5) steht X gleich oder verschieden bei jedem Auftreten für CR¹.

Bevorzugt sind die Teilliganden Ar¹-Ar² bidentate monoanionische Liganden, welche mit dem Übergangsmetall M einen cyclometallierten Fünfring mit mindestens einer Metall-Kohlenstoff-Bindung aufweisen. Dies sind insbesondere Liganden, wie sie allgemein im Gebiet der phosphoreszierenden Metallkomplexe für organische Elektrolumineszenzvorrichtungen verwendet werden, also Liganden vom Typ Phenylpyridin, Naphthylpyridin, Phenylchinolin, Phenylisochinolin, etc., welche jeweils durch einen oder mehrere Reste R¹ substituiert sein können. Bevorzugt eignet sich als Gruppe Ar¹ jeweils eine der folgenden Gruppen (6) bis (16) und als Gruppe Ar² jeweils eine der folgenden Gruppen (17) bis (38). Dabei sind die Gruppen bevorzugt derart gewählt, dass eine der Gruppen Ar¹ bzw. Ar² im Teilliganden Ar¹-Ar² über ein neutrales Stickstoffatom oder ein Carbenkohlenstoffatom bindet und die andere der Gruppen Ar¹ bzw. Ar² im Teilliganden Ar¹-Ar² über ein negativ geladenes Kohlenstoffatom oder ein negativ geladenes Stickstoffatom bindet.

Geeignete Strukturen Ar¹ sind somit die Strukturen der folgenden Formeln (6) bis (16),

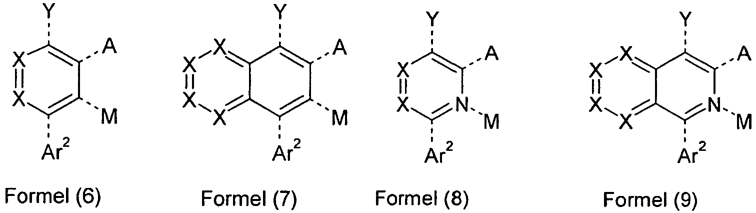

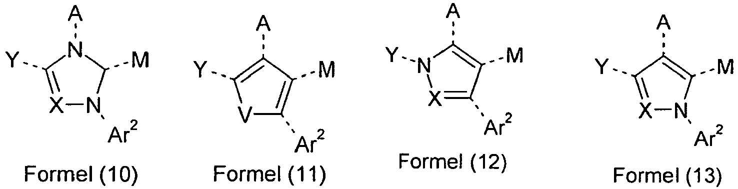

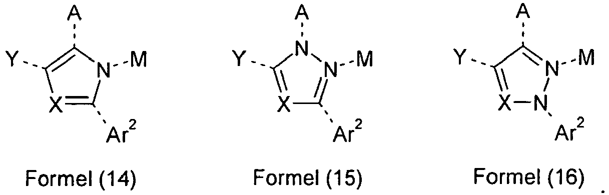

Geeignete Strukturen Ar² sind die Strukturen der folgenden Formeln (17) bis (38),

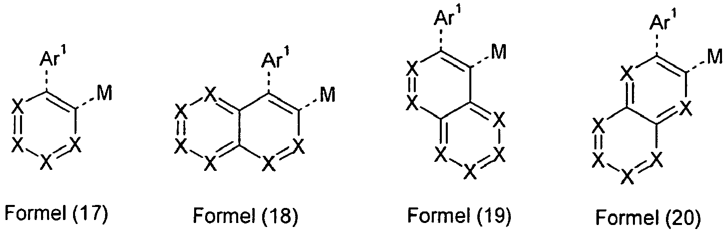

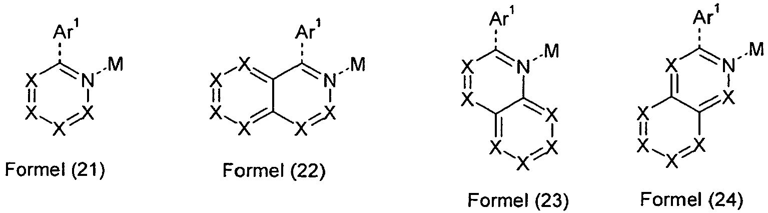

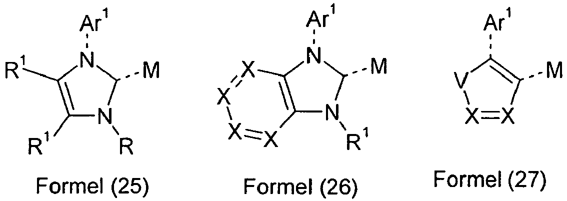

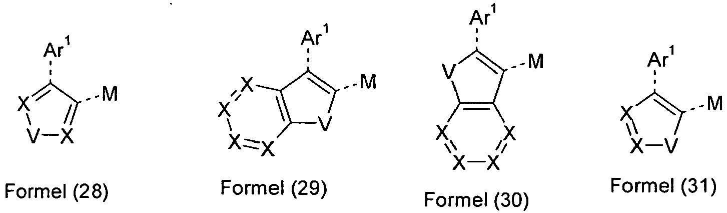

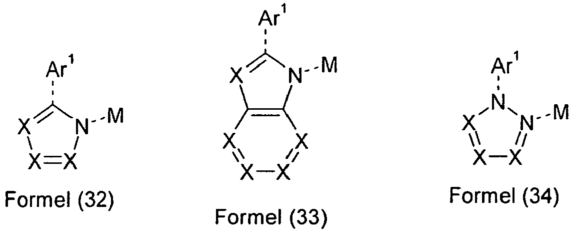

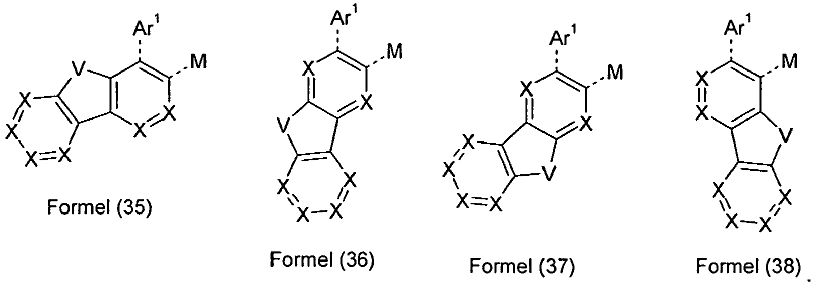

In den Strukturen der Formeln (6) bis (38) ist durch gestrichelte Bindungen jeweils die Bindung an A, Y, M und Ar¹ bzw. Ar² angedeutet.

Dabei steht X in den Formeln (6) bis (38) bei jedem Auftreten gleich oder verschieden für CR¹ oder N, V steht bei jedem Auftreten gleich oder verschieden für O, S oder NR¹, und R hat dieselbe Bedeutung wie oben beschrieben. Bevorzugt stehen maximal drei Symbole X in jeder Gruppe für N, besonders bevorzugt stehen maximal zwei Symbole X in jeder Gruppe für N, ganz besonders bevorzugt steht maximal ein Symbol X in jeder Gruppe für N. Insbesondere bevorzugt stehen alle Symbole X für CR¹.

Wie oben aufgeführt, können zwei Reste an benachbarten Gruppen Ar¹ und Ar² auch miteinander einen Ring bilden. Ein solcher Ringschluss erfolgt bevorzugt über eine Gruppe CR²=CR² bzw. über eine Gruppe CR²=N. Dadurch kann auch eine neue Aryl- bzw. Heteroarylgruppe entstehen, so dass Ar¹ und Ar² nicht mehr separate Arylgruppen darstellen. Dies wird im Folgenden veranschaulicht am Beispiel mit Ar¹ = Phenyl und Ar² = Pyridin, wobei durch eine solche Ringschlussreaktion eine Phenanthridinstruktur entsteht. Analoge Ringschlussreaktionen sind auch mit anderen Gruppen Ar¹ und Ar² möglich.

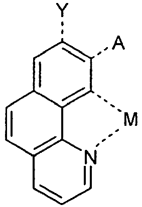

Bevorzugte Reste R¹ an Ar¹, Ar² bzw. Ar³ sind bei jedem Auftreten gleich oder verschieden ausgewählt aus der Gruppe bestehend aus H, D, F, Br, I, N(R²)₂, CN, Si(R²)₃, B(OR²)₂, C(=O)R², einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, die jeweils mit einem oder mehreren Resten R² substituiert sein kann, wobei ein oder mehrere H-Atome durch D oder F ersetzt sein können, oder einem aromatischen oder heteroaromatischen Ringsystem mit 5 bis 30 aromatischen Ringatomen, das jeweils durch einen oder mehrere Reste R² substituiert sein kann; dabei können zwei benachbarte Reste R¹ oder zwei Reste R¹ an benachbarten Gruppen Ar¹ und Ar² auch miteinander ein mono- oder polycyclisches, aliphatisches Ringsystem bilden. Besonders bevorzugt sind diese Reste R¹ bei jedem Auftreten gleich oder verschieden ausgewählt aus der Gruppe bestehend aus H, D, F, N(R²)₂, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch D oder F ersetzt sein können, oder einem aromatischen oder heteroaromatischen Ringsystem mit 5 bis 24 aromatischen Ringatomen, das jeweils durch einen oder mehrere Reste R² substituiert sein kann; dabei können zwei benachbarte Reste R oder R mit R¹ auch miteinander ein mono- oder polycyclisches, aliphatisches Ringsystem bilden.

Wenn die Gruppe Y für eine Gruppe NR steht, dann steht die Gruppe R bevorzugt gleich oder verschieden bei jedem Auftreten für ein aromatisches oder heteroaromatisches Ringsystem mit 5 bis 18 aromatischen Ringatomen, das jeweils durch einen oder mehrere Reste R² substituiert sein kann und das bevorzugt keine kondensierten Aryl- oder Heteroarylgruppen enthält.

Wenn die Gruppe Y für eine Gruppe CR₂ steht, dann steht die Gruppe R gleich oder verschieden bei jedem Auftreten bevorzugt für H, D, eine geradkettige Alkylgruppe mit 1 bis 10 C-Atomen oder eine Alkenyl- oder Alkinylgruppe mit 2 bis 10 C-Atomen oder eine verzweigte oder cyclische Alkylgruppe mit 3 bis 10 C-Atomen, die jeweils mit einem oder mehreren Resten R² substituiert sein kann, wobei ein oder mehrere H-Atome durch D oder F ersetzt sein können, oder ein aromatisches oder heteroaromatisches Ringsystem mit 5 bis 18 aromatischen Ringatomen, das jeweils durch einen oder mehrere Reste R² substituiert sein kann und das bevorzugt keine kondensierten Aryl- oder Heteroarylgruppen enthält; dabei können zwei oder mehrere Reste R, welche an dasselbe Kohlenstoffatom binden, auch miteinander ein mono- oder polycyclisches, aliphatisches oder aromatisches Ringsystem bilden. Besonders bevorzugte Reste R sind bei jedem Auftreten gleich oder verschieden ausgewählt aus der Gruppe bestehend aus H, einer geradkettigen Alkylgruppe mit 1 bis 5 C-Atomen, insbesondere Methyl, oder einer verzweigten oder cyclischen Alkylgruppe mit 3 bis 5 C-Atomen, insbesondere iso-Propyl oder tert-Butyl, wobei ein oder mehrere H-Atome durch D oder F ersetzt sein können, oder einem aromatischen oder heteroaromatischen Ringsystem mit 5 bis 12 aromatischen Ringatomen, das jeweils durch einen oder mehrere Reste R² substituiert sein kann; dabei können zwei Reste R, die an dasselbe Kohlenstoffatom binden, auch miteinander ein mono- oder polycyclisches, aliphatisches oder aromatisches Ringsystem bilden.

Wenn die Reste R, die an dasselbe Kohlenstoffatom binden, miteinander ein Ringsystem bilden, dann handelt es sich in einer bevorzugten Ausführungsform der Erfindung um eine Struktur der folgenden Formel (a), Formel (b) oder Formel (c), 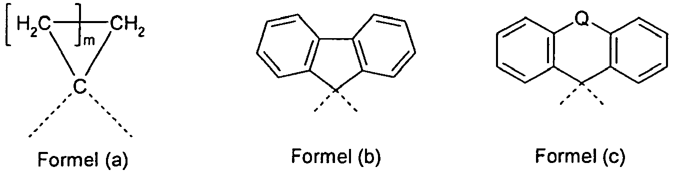 wobei Q für C(R²)₂, NR², O oder S steht, die Strukturen auch durch einen oder mehrere Reste R² substituiert sein können und m bevorzugt für 1, 2, 3, 4 oder 5 steht, besonders bevorzugt für 3 oder 4. Die gestrichelt dargestellten Bindungen stehen dabei für die Bindung der Gruppe an Ar¹ und Ar³.

Die oben genannten bevorzugten Ausführungsformen sind beliebig miteinander kombinierbar. In einer besonders bevorzugten Ausführungsform der Erfindung gelten die oben genannten bevorzugten Ausführungsformen gleichzeitig.

In einer bevorzugten Ausführungsform der Erfindung gilt daher für die Verbindungen der Formel (1):
- M: ist ausgewählt aus der Gruppe bestehend aus Platin, Palladium, Nickel, Rhodium, Iridium und Gold, insbesondere Pt(II), Pd(II), Ni(II), Rh(I), Ir(I) und Au(III);
- D: ist bei jedem Auftreten gleich oder verschieden C oder N, wobei zwei Gruppen D für N stehen und die anderen beiden Gruppen D für C stehen;
- A: ist N oder P;
- Y: ist gleich oder verschieden bei jedem Auftreten CR₂ oder eine Einfachbindung, wobei maximal eine Gruppe Y für eine Einfachbindung steht;
- Ar³: ist ausgewählt aus den oben genannten Strukturen der Formeln (3), (4) oder (5);
- Ar¹: ist ausgewählt aus den oben genannten Strukturen der Formeln (6) bis (16);
- Ar²: ist ausgewählt aus den oben genannten Strukturen der Formeln (17) bis (38);
- R¹: ist bei jedem Auftreten gleich oder verschieden ausgewählt aus der Gruppe bestehend aus H, D, F, Br, I, N(R²)₂, CN, Si(R²)₃, B(OR²)₂, C(=O)R², einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, die jeweils mit einem oder mehreren Resten R² substituiert sein kann, wobei ein oder mehrere H-Atome durch D oder F ersetzt sein können, oder einem aromatischen oder heteroaromatischen Ringsystem mit 5 bis 30 aromatischen Ringatomen, das jeweils durch einen oder mehrere Reste R² substituiert sein kann; dabei können zwei benachbarte Reste R¹ oder zwei Reste R¹ an benachbarten Gruppen Ar¹ und Ar² auch miteinander ein mono- oder polycyclisches, aliphatisches Ringsystem bilden;
- R: ist für Y = NR gleich oder verschieden bei jedem Auftreten ein aromatisches oder heteroaromatisches Ringsystem mit 5 bis 18 aromatischen Ringatomen, das jeweils durch einen oder mehrere Reste R² substituiert sein kann und das bevorzugt keine kondensierten Aryl- oder Heteroarylgruppen enthält;
und ist für Y = CR₂ gleich oder verschieden H, D, eine geradkettige Alkylgruppe mit 1 bis 10 C-Atomen oder eine Alkenyl- oder Alkinylgruppe mit 2 bis 10 C-Atomen oder eine verzweigte oder cyclische Alkylgruppe mit 3 bis 10 C-Atomen, die jeweils mit einem oder mehreren Resten R² substituiert sein kann, wobei ein oder mehrere H-Atome durch D oder F ersetzt sein können, oder ein aromatisches oder heteroaromatisches Ringsystem mit 5 bis 18 aromatischen Ringatomen, das jeweils durch einen oder mehrere Reste R² substituiert sein kann und das bevorzugt keine kondensierten Aryl- oder Heteroarylgruppen enthält; dabei können zwei oder mehrere Reste R, welche an dasselbe Kohlenstoffatom binden, auch miteinander ein mono- oder polycyclisches, aliphatisches oder aromatisches Ringsystem bilden.

In einer besonders bevorzugten Ausführungsform der Erfindung gilt für die Verbindungen der Formel (1) bzw. Formel (2):
- M: ist ausgewählt aus der Gruppe bestehend aus Pt(II), Ir(I) und Au(III), insbesondere Pt(II).
- D: ist in beiden Gruppen Ar¹ gleich N und in beiden Gruppen Ar² gleich C oder ist in beiden Gruppen Ar¹ gleich C und in beiden Gruppen Ar² gleich N;
- A: ist N;
- Y: ist bei jedem Auftreten CR₂, wobei beide Gruppen Y gleich gewählt sind;
- Ar³: ist ausgewählt aus den oben genannten Strukturen der Formel (3);
- Ar¹: ist ausgewählt aus den oben genannten Strukturen der Formeln (6) bis (16);
- Ar²: ist ausgewählt aus den oben genannten Strukturen der Formeln (17) bis (38);
- R¹: ist bei jedem Auftreten gleich oder verschieden ausgewählt aus der Gruppe bestehend aus H, D, F, N(R²)₂, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch D oder F ersetzt sein können, oder einem aromatischen oder heteroaromatischen Ringsystem mit 5 bis 24 aromatischen Ringatomen, das jeweils durch einen oder mehrere Reste R² substituiert sein kann; dabei können zwei benachbarte Reste R oder R mit R¹ auch miteinander ein mono- oder polycyclisches, aliphatisches Ringsystem bilden;
- R: ist für Y = NR gleich oder verschieden bei jedem Auftreten ein aromatisches oder heteroaromatisches Ringsystem mit 5 bis 18 aromatischen Ringatomen, das jeweils durch einen oder mehrere Reste R² substituiert sein kann und das bevorzugt keine kondensierten Aryl- oder Heteroarylgruppen enthält;
und ist für Y = CR₂ gleich oder verschieden ausgewählt aus der Gruppe bestehend aus H, einer geradkettigen Alkylgruppe mit 1 bis 5 C-Atomen, insbesondere Methyl, oder einer verzweigten oder cyclischen Alkylgruppe mit 3 bis 5 C-Atomen, insbesondere iso-Propyl oder tert-Butyl, wobei ein oder mehrere H-Atome durch D oder F ersetzt sein können, oder einem aromatischen oder heteroaromatischen Ringsystem mit 5 bis 12 aromatischen Ringatomen, das jeweils durch einen oder mehrere Reste R² substituiert sein kann; dabei können zwei Reste R, die an dasselbe Kohlenstoffatom binden, auch miteinander ein mono- oder polycyclisches, aliphatisches oder aromatisches Ringsystem bilden.

Die Liganden der erfindungsgemäßen Verbindungen können gemäß Schema 1 dargestellt werden.

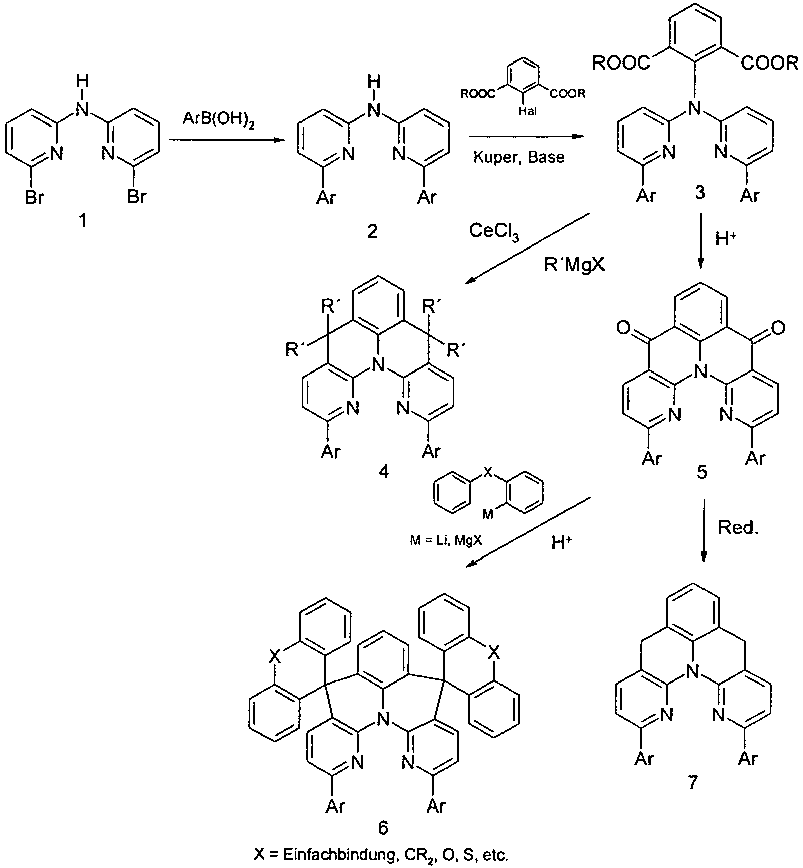

Das Dibromid 1 kann durch Suzuki-Kupplung zu 2 umgesetzt werden. Reaktion von 2 via Ullmann-Kupplung mit 2-Halogen-isophthalsäureestern und anschließende saure Cyclisierung führt zum Bisketon 5, welches durch Reduktion mit Hydrazinhydrat oder BH₃ x THF zum Liganden 7 umgesetzt werden kann. Eine Addition von geeigneten Aryllithium bzw. Aryl-Magnesium-Verbindungen und nachfolgende saure Cyclisierung des intermediär gebildeten Diols führt zu Liganden vom Typ 6. Liganden vom Typ 4 können aus 3 durch Cer-vermittelte Grignardaddition und anschließende Cyclisierung des intermediär gebildeten Diols erhalten werden. Diese Strukturen können selbstverständlich auch noch weitere Substituenten aufweisen. Eine weitergehende Funktionalisierung der Liganden vom Typ 4, 6 und 7 ist nach Schema 2 via Halogenierung und C-C- bzw. C-N-Kupplung möglich.

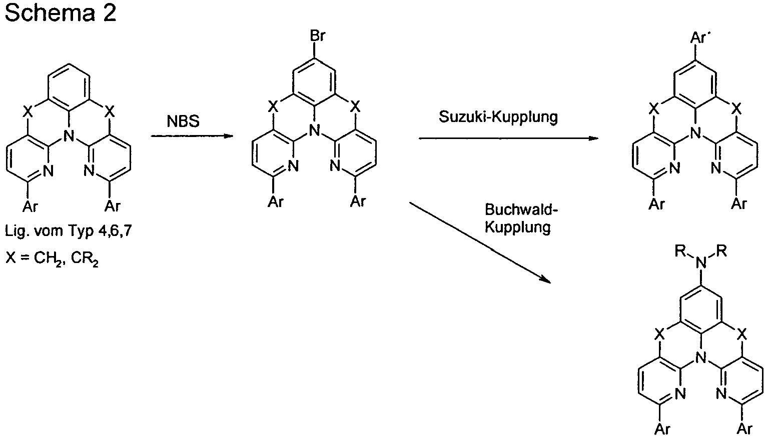

Eine weitere Möglichkeit Liganden vom Typus 15, 16 und 17 darzustellen ist in Schema 3 aufgezeigt, wobei sich der Syntheseablauf ähnlichen Schritten wie in Schema 1 gezeigt bedient.

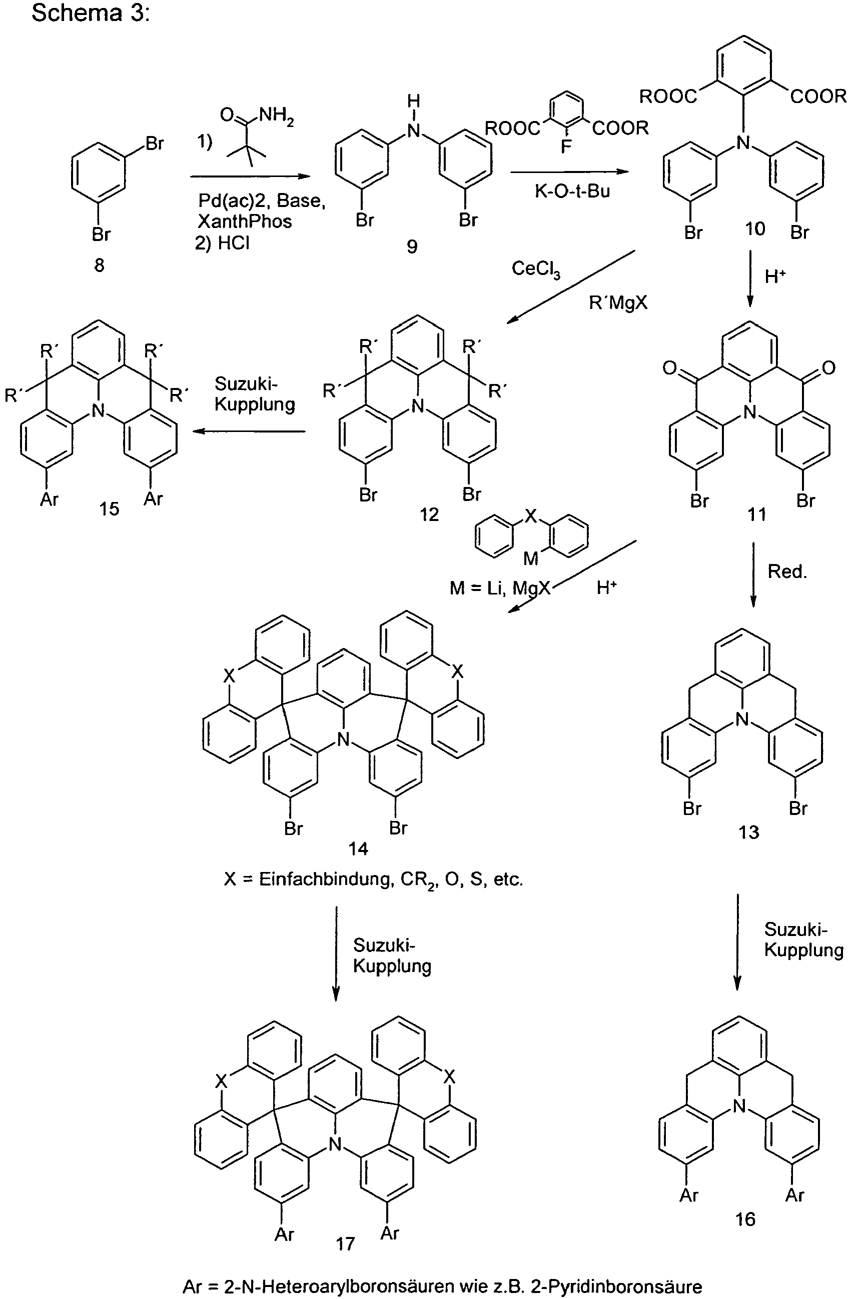

Die Komplexierung der Liganden vom Typus 4, 6, 7, 15, 16 und 17 zu den erfindungsgemäßen Komplexen kann, wie in Schema 4 an Liganden des Typs 4 gezeigt, erfolgen, wobei ganz analog auch andere Pt-Precursor verwendet werden können.

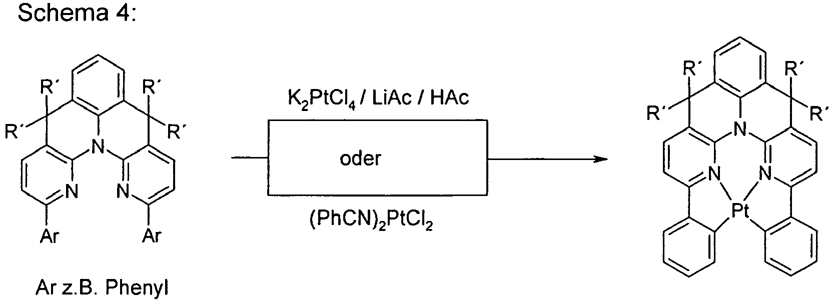

Die erfindungsgemäßen Metallkomplexe sind prinzipiell durch verschiedene Verfahren darstellbar, bei denen der Ligand mit einer geeigneten Metallvorstufe umgesetzt wird. Daher ist ein weiterer Gegenstand der vorliegenden Erfindung ein Verfahren zur Herstellung der Verbindungen gemäß Formel (1) durch Umsetzung des entsprechenden freien Liganden mit einer geeigneten Metallverbindung. Geeignete Platin-Edukte sind beispielsweise PtCl₂, K₂[PtCl₄], PtCl₂(DMSO)₂, Pt(Me)₂(DMSO)₂, PtCl₂(Benzonitril)₂, PtCl₂(Acetonitril)₂ oder Pt-Olefin-Komplexe, wie z. B. (COD)PtCl₂. Geeignete Iridium-Edukte sind beispielsweise Iridium(III)-chlorid-Hydrat, Iridium-Olefin-Komplexe, beispielsweise mit COD als Ligand, Ir(acac)₃, Ir(tBu-acac)₃ oder Vaskas Komplex. Geeignete Gold-Edukte sind beispielsweise AuCl₃ oder HAuCl₄.

Die Synthese kann auch thermisch, photochemisch und/oder durch Mikrowellenstrahlung aktiviert werden. In einer möglichen Ausführungsform der Erfindung wird die Reaktion ohne die Verwendung eines zusätzlichen Lösemittels in der Schmelze durchgeführt. Dabei bedeutet "Schmelze", dass der Ligand geschmolzen vorliegt und die Metall-Vorstufe in dieser Schmelze gelöst oder suspendiert ist. In einer weiteren möglichen Ausführungsform der Erfindung wird der entsprechende freie Ligand mit der Metallvorstufe, beispielsweise K₂PtCl₄, in Eisessig umgesetzt.

Durch diese Verfahren, gegebenenfalls gefolgt von Aufreinigung, wie z. B. Umkristallisation oder Sublimation, lassen sich die erfindungsgemäßen Verbindungen gemäß Formel (1) in hoher Reinheit, bevorzugt mehr als 99 % (bestimmt mittels ¹H-NMR und/oder HPLC) erhalten.

Beispiele für geeignete erfindungsgemäße Verbindungen sind die in der folgenden Tabelle aufgeführten Strukturen.

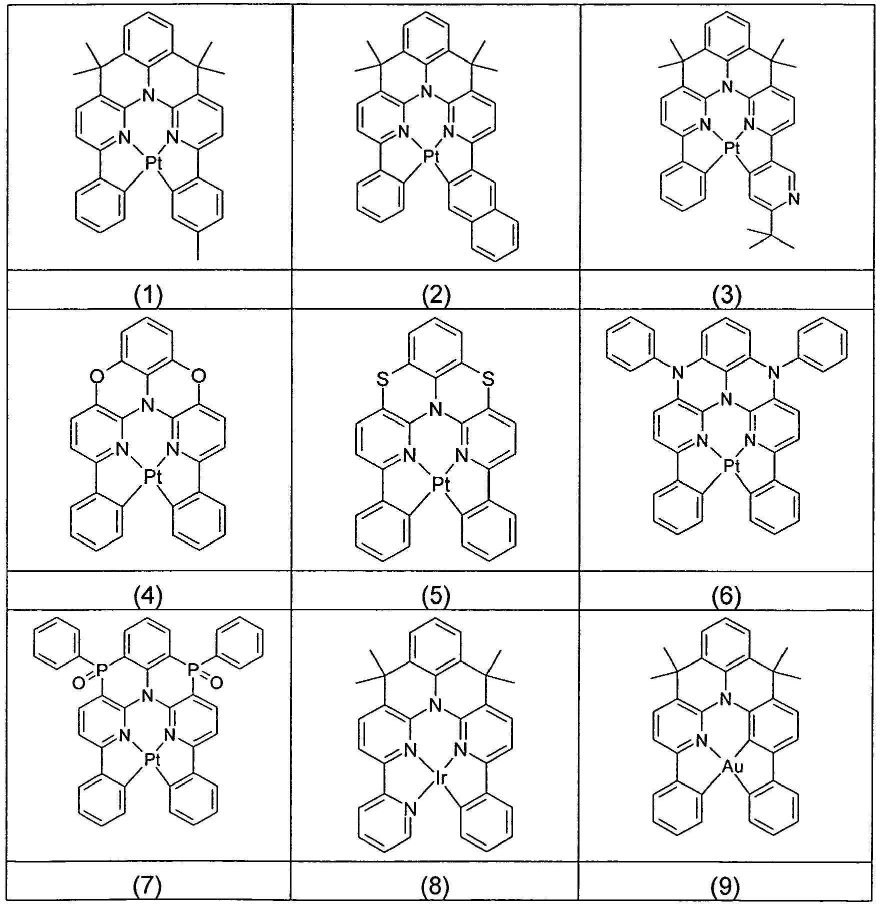

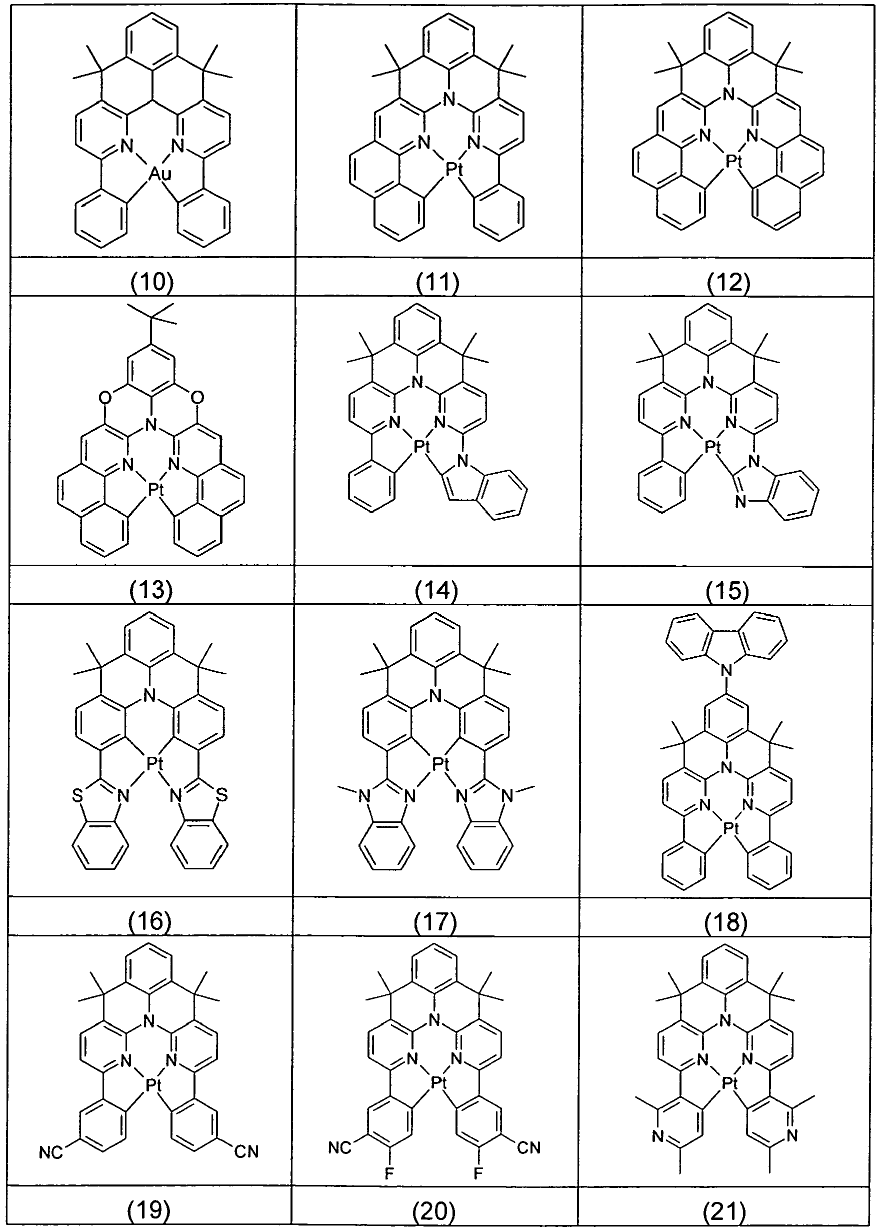

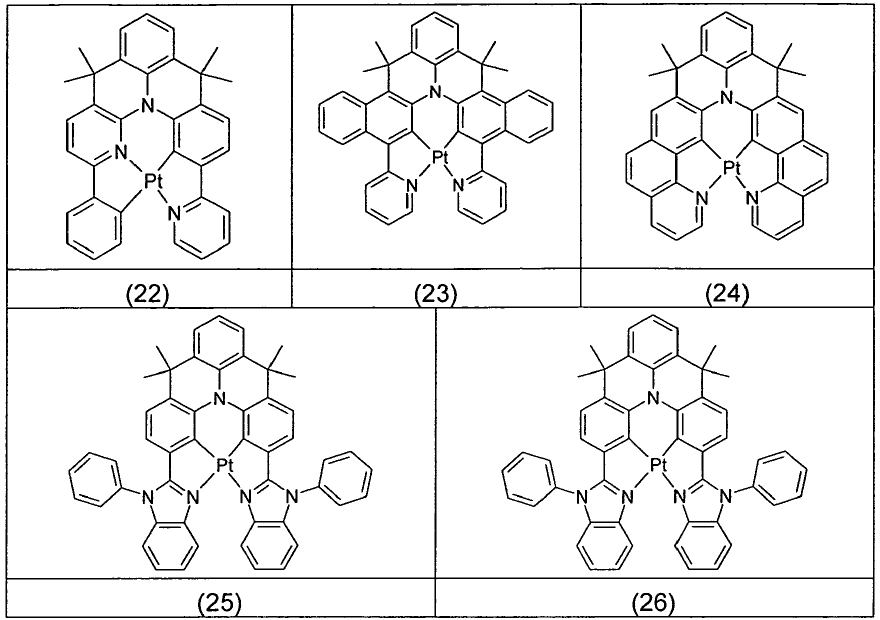

Die erfindungsgemäßen Verbindungen können auch durch geeignete Substitution, beispielsweise durch längere Alkylgruppen (ca. 4 bis 20 C-Atome), insbesondere verzweigte Alkylgruppen, oder gegebenenfalls substituierte Arylgruppen, beispielsweise Xylyl-, Mesityl- oder verzweigte Terphenyl- oder Quaterphenylgruppen, löslich gemacht werden. Solche Verbindungen sind dann in gängigen organischen Lösemitteln, wie beispielsweise Toluol oder Xylol bei Raumtemperatur in ausreichender Konzentration löslich, um die Komplexe aus Lösung verarbeiten zu können. Diese löslichen Verbindungen eignen sich besonders gut für die Verarbeitung aus Lösung, beispielsweise durch Druckverfahren.

Ein weiterer Gegenstand der vorliegenden Erfindung ist daher eine Formulierung, insbesondere eine Lösung, eine Suspension oder eine Miniemulsion, enthaltend mindestens eine Verbindung gemäß Formel (1) und mindestens ein Lösemittel.

Nochmals ein weiterer Gegenstand der vorliegenden Erfindung ist eine Mischung, enthaltend mindestens eine Verbindung gemäß Formel (1) und mindestens eine weitere Verbindung, insbesondere eine weitere Verbindung, welche sich als Matrixmaterial für die Verbindung gemäß Formel (1) eignet.

Die oben beschriebenen Komplexe gemäß Formel (1) bzw. die oben aufgeführten bevorzugten Ausführungsformen können in der elektronischen Vorrichtung als aktive Komponente verwendet werden. Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens eine Verbindung der oben aufgeführten Formel (1) enthält. Dabei sind bevorzugte elektronische Vorrichtungen ausgewählt aus der Gruppe bestehend aus organischen Elektrolumineszenzvorrichtungen (OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs), lichtemittierenden elektrochemischen Zellen (LECs) oder organischen Laserdioden (O-Laser), enthaltend in mindestens einer Schicht mindestens eine Verbindung gemäß der oben aufgeführten Formel (1). Besonders bevorzugt sind organische Elektrolumineszenzvorrichtungen. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäßen Verbindungen zeigen besonders gute Eigenschaften als Emissionsmaterial in organischen Elektrolumineszenzvorrichtungen. Eine bevorzugte Ausführungsform der Erfindung sind daher organische Elektrolumineszenzvorrichtungen.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Ebenso können zwischen zwei emittierende Schichten Interlayers eingebracht sein, welche beispielsweise eine Excitonen-blockierende Funktion aufweisen und/oder die Ladungsbalance in der Elektrolumineszenzvorrichtung steuern. Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 2005/011013) bzw. Systeme, welche mehr als drei emittierende Schichten aufweisen. Es kann sich auch um ein Hybrid-System handeln, wobei eine oder mehrere Schichten fluoreszieren und eine oder mehrere andere Schichten phosphoreszieren.

In einer bevorzugten Ausführungsform der Erfindung enthält die organische Elektrolumineszenzvorrichtung die Verbindung gemäß Formel (1) bzw. die oben aufgeführten bevorzugten Ausführungsformen als emittierende Verbindung in einer oder mehreren emittierenden Schichten.

Wenn die Verbindung gemäß Formel (1) als emittierende Verbindung in einer emittierenden Schicht eingesetzt wird, wird sie bevorzugt in Kombination mit einem oder mehreren Matrixmaterialien eingesetzt. Die Mischung aus der Verbindung gemäß Formel (1) und dem Matrixmaterial enthält zwischen 0.1 und 99 Vol.-%, vorzugsweise zwischen 1 und 90 Vol.-%, besonders bevorzugt zwischen 3 und 40 Vol.-%, insbesondere zwischen 5 und 15 Vol.-% der Verbindung gemäß Formel (1) bezogen auf die Gesamtmischung aus Emitter und Matrixmaterial. Entsprechend enthält die Mischung zwischen 99.9 und 1 Vol.-%, vorzugsweise zwischen 99 und 10 Vol.-%, besonders bevorzugt zwischen 97 und 60 Vol.-%, insbesondere zwischen 95 und 85 Vol.-% des Matrixmaterials bezogen auf die Gesamtmischung aus Emitter und Matrixmaterial.

Als Matrixmaterial können generell alle Materialien eingesetzt werden, die gemäß dem Stand der Technik hierfür bekannt sind. Bevorzugt ist das Triplett-Niveau des Matrixmaterials höher als das Triplett-Niveau des Emitters.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Bis-carbazolylbiphenyl), m-CBP oder die in WO 2005/039246, US 2005/0069729, JP 2004/288381, EP 1205527, WO 2008/086851 oder US 2009/0134784 offenbarten Carbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Dibenzofuranderivate, z. B. gemäß WO 2009/148015, oder verbrückte Carbazolderivate, z. B. gemäß US 2009/0136779, WO 2010/050778, WO 2011/042107 oder WO 2011/088877.

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Eine bevorzugte Kombination ist beispielsweise die Verwendung eines aromatischen Ketons, eines Triazin-Derivats oder eines Phosphinoxid-Derivats mit einem Triarylamin-Derivat oder einem Carbazol-Derivat als gemischte Matrix für den erfindungsgemäßen Metallkomplex. Ebenso bevorzugt ist die Verwendung einer Mischung aus einem ladungstransportierenden Matrixmaterial und einem elektrisch inerten Matrixmaterial, welches nicht bzw. nicht in wesentlichem Maße am Ladungstransport beteiligt ist, wie z. B. in WO 2010/108579 beschrieben.

Weiterhin bevorzugt ist es, eine Mischung aus zwei oder mehr Triplett-Emittern zusammen mit einer Matrix einzusetzen. Dabei dient der Triplett-Emitter mit dem kürzerwelligen Emissionsspektrum als Co-Matrix für den Triplett-Emitter mit dem längerwelligen Emissionsspektrum. So können beispielsweise die erfindungsgemäßen Komplexe gemäß Formel (1) als Co-Matrix für längerwellig emittierende Triplettemitter, beispielsweise für grün oder rot emittierende Triplettemitter, eingesetzt werden.

Die erfindungsgemäßen Verbindungen lassen sich auch in anderen Funktionen in der elektronischen Vorrichtung einsetzen, beispielsweise als Lochtransportmaterial in einer Lochinjektions- oder -transportschicht, als Ladungserzeugungsmaterial oder als Elektronenblockiermaterial. Ebenso lassen sich die erfindungsgemäßen Komplexe als Matrixmaterial für andere phosphoreszierende Metallkomplexe in einer emittierenden Schicht einsetzen.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Ebenso kommen hierfür organische Alkalimetallkomplexe in Frage, z. B. Liq (Lithiumchinolinat). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOₓ) bevorzugt sein. Für einige Anwendungen muss mindestens eine der Elektroden transparent oder teiltransparent sein, um entweder die Bestrahlung des organischen Materials (O-SC) oder die Auskopplung von Licht (OLED/PLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere, z. B. PEDOT, PANI oder Derivate dieser Polymere.

In den weiteren Schichten können generell alle Materialien verwendet werden, wie sie gemäß dem Stand der Technik für die Schichten verwendet werden, und der Fachmann kann ohne erfinderisches Zutun jedes dieser Materialien in einer elektronischen Vorrichtung mit den erfindungsgemäßen Materialien kombinieren.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner 10⁻⁵ mbar, bevorzugt kleiner 10⁻⁶ mbar aufgedampft. Es ist auch möglich, dass der Anfangsdruck noch geringer oder noch höher ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck oder Nozzle-Printing, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden.

Die organische Elektrolumineszenzvorrichtung kann auch als Hybrid-system hergestellt werden, indem eine oder mehrere Schichten aus Lösung aufgebracht werden und eine oder mehrere andere Schichten aufgedampft werden. So ist es beispielsweise möglich, eine emittierende Schicht enthaltend eine Verbindung gemäß Formel (1) und ein Matrixmaterial aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf organische Elektrolumineszenzvorrichtungen enthaltend Verbindungen gemäß Formel (1) bzw. die oben aufgeführten bevorzugten Ausführungsformen angewandt werden.

Die erfindungsgemäßen elektronischen Vorrichtungen, insbesondere organische Elektrolumineszenzvorrichtungen, zeichnen sich durch einen oder mehrere der folgenden überraschenden Vorteile gegenüber dem Stand der Technik aus:
1. Organische Elektrolumineszenzvorrichtungen enthaltend Verbindungen gemäß Formel (1) als emittierende Materialien weisen eine sehr gute Lebensdauer auf.
2. Organische Elektrolumineszenzvorrichtungen enthaltend Verbindungen gemäß Formel (1) als emittierende Materialien weisen eine hervorragende Effizienz auf.
3. Mit den erfindungsgemäßen Metallkomplexen sind organische Elektrolumineszenzvorrichtungen zugänglich, welche im blauen Farbbereich phosphoreszieren. Insbesondere blaue Phosphoreszenz ist gemäß dem Stand der Technik nur sehr schwierig mit guten Effizienzen und Lebensdauern zu verwirklichen.
4. Die erfindungsgemäßen Metallkomplexe sind synthetisch gut und in hoher Ausbeute zugänglich.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße elektronische Vorrichtungen herstellen und somit die Erfindung im gesamten beanspruchten Bereich ausführen.

### Beispiele:

Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht gehandhabt. Die Lösungsmittel und Reagenzien können z. B. von Sigma-ALDRICH bzw. ABCR bezogen werden. Die Angaben in eckigen Klammern zu literaturbekannten chemischen Verbindungen beziehen sich auf die CAS-Nummer.

### A: Synthese von Synthonen S:

### 1) Bis-(6-Phenyl-pyridin-2-yl)-amin S1

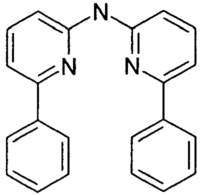

Ein Gemisch aus 32.9 g (100 mmol) Bis-(6-Brompyridin-2-yl)-amin [1195970-59-2], 29.3 g (240 mmol) Phenylboronsäure, 42.4 g (400 mmol) Natriumcarbonat, 400 ml Toluol, 200 ml Dioxan und 400 ml Wasser wird unter Rühren mit 1.8 g (6 mmol) Tri-o-tolylphosphin und dann 225 mg (1 mmol) Palladium(II)acetat versetzt und 16 h unter Rückfluss erhitzt. Nach Erkalten trennt man die organische Phase ab, wäscht diese mit 500 ml Wasser und 500 ml gesättigter Kochsalzlösung und trocknet dann über Natriumsulfat. Nach Entfernen des Lösungsmittels wird der Rückstand zweimal aus Essigsäureethylester / Ethanol umkristallisiert. Ausbeute: 27.0 g (83 mmol), 83.5 %; Reinheit: ca. 97 % ig n. ¹H-NMR.

Analog werden folgende Verbindungen dargestellt:

| Bsp. | Boronsäure | Produkt | Ausbeute |
|---|---|---|---|
| 2 | 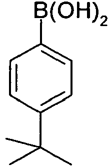 | 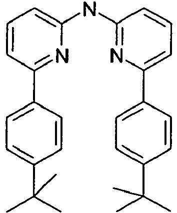 | 80 % |
| | [123324-71-0] | S2 | |
| 3 | 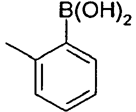 | 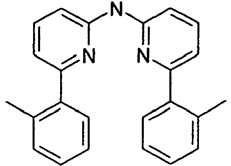 | 78 % |
| | [16419-60-6] | S3 | |
| 4 | 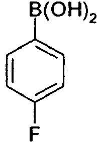 | 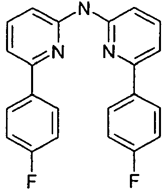 | 73 % |
| | [1765-93-1] | S4 | |
| 5 | 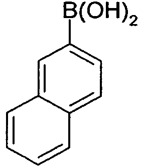 | 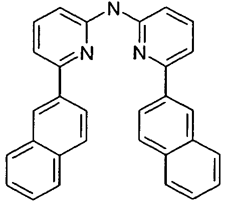 | 56 % |
| | [32316-92-0] | S5 | |
| 6 | 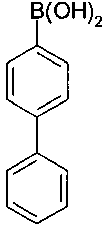 | 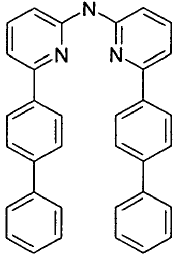 | 81 % |
| | | S6 | |
| 7 | 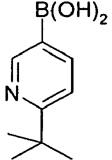 | 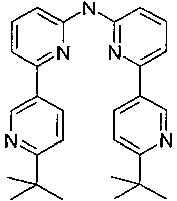 | 48 % |
| | [1174312-53-8] | S7 | |
| 8 | 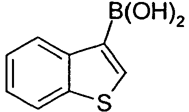 | 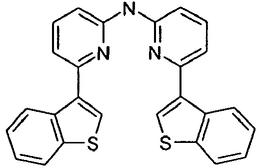 | 55 % |
| | [113893-08-6] | S8 | |

### 9) 2-[Bis-6-phenyl-pyridin-2-yl]-amino]-isophthalsäuredimethylester S9

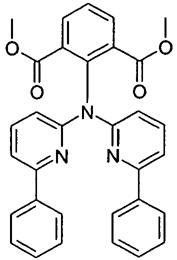

Ein Gemisch aus 32.3 g (100 mmol) S1, 27.3 g (110 mmol) 2-Brom-iso-phthalsäuredimethylester [39622-80-5], 20.7 g (150 mmol) Kaliumcarbonat, 1.3 g (20 mmol) Kupferbronze, 150 ml Diphenylether und 100 g Glaskugeln (Durchmesser 5 mm) wird unter gutem Rühren 30 h auf 200 °C erhitzt. Nach Erkalten wird mit 500 ml Toluol verdünnt, die Salze und Glaskugeln werden abfiltriert und das Filtrat wird im Vakuum von allen flüchtigen Anteilen befreit. Der Rückstand wird in 500 ml Dichlormethan aufgenommen, die organische Phase wird dreimal mit Wasser gewaschen und über Natriumsulfat getrocknet. Das Dichlormethan wird durch Destillation entfernt, wobei kontinuierlich ein gleiches Volumen an Methanol zugegeben wird. Nach Umstellen auf Methanol destilliert man dieses langsam ab, bis die Kristallisation einsetzt. Nach Erkalten saugt man vom Feststoff ab, wäscht diesen dreimal mit 100 ml Methanol und trocknet im Vakuum. Ausbeute: 40.3 g (78 mmol), 78.1 %; Reinheit: ca. 97 %ig nach ¹H-NMR.

Analog werden - unter Verwendung der entsprechenden iso-Phthalsäureester - folgende Verbindungen dargestellt:

| Bsp. | S | Produkt | Ausbeute |
|---|---|---|---|
| 10 | 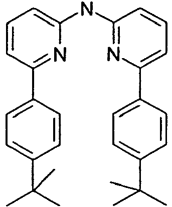 | 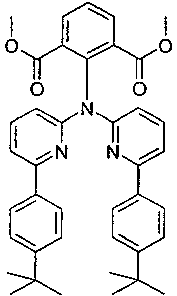 | 66 % |
| | S2 | S10 | |
| 11 | 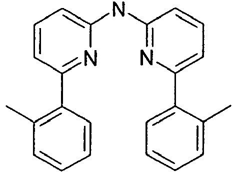 | 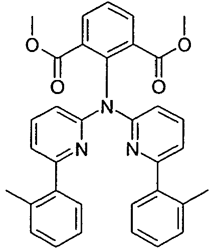 | 58 % |
| | S3 | S11 | |
| 12 | 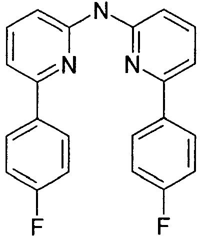 | 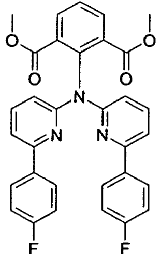 | 70 % |
| | S4 | S12 | |
| 13 | 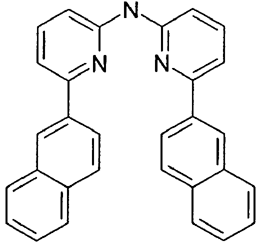 | 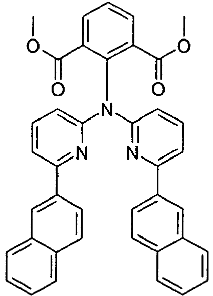 | 68 % |
| | S5 | S13 | |
| 14 | 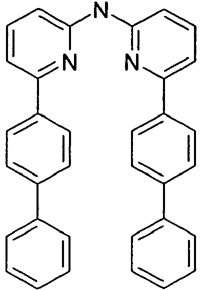 | 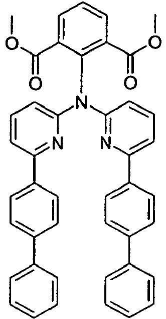 | 71 % |
| | S6 | S14 | |
| 15 | 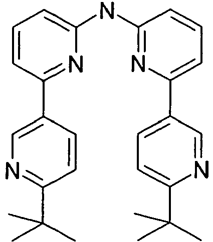 | 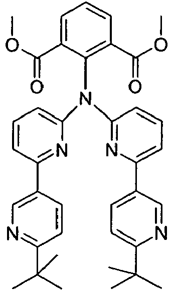 | 54 % |
| | S7 | S15 | |
| 16 | 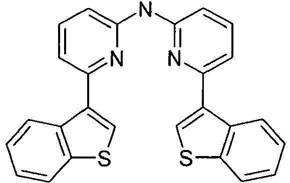 | 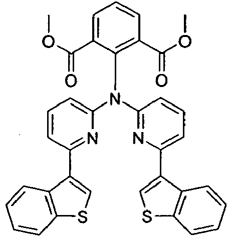 | 57 % |
| | S8 | S16 | |
| 17 | 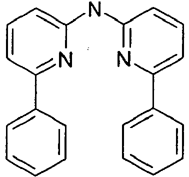 | 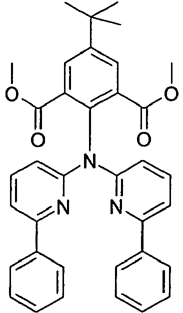 | 74% |
| | S1 | S17 | |

### 18) 2,12-Diphenyl-1,13,13b-triaza-naphtho[3,2,1-de]anthracen-5,9-dion S18

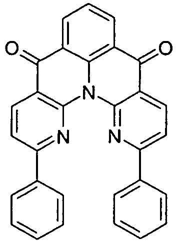

In einer Apparatur mit Destillationsbrücke wird ein auf 150 °C erwärmtes Gemisch aus 300 ml o-Dichlorbenzol und 100 ml konz. Schwefelsäure vorgelegt. Dazu wird unter gutem Rühren während 30 min. eine Lösung von 51.6 g (100 mmol) S9 in 200 ml o-Dichlorbenzol getropft. Man rührt nach, bis sich kein Methanol mehr abscheidet, lässt erkalten, gießt auf 1000 ml Eiswasser, stellt vorsichtig mit NaOH auf pH = 10 ein, gibt 1000 ml Dichlormethan zu, rührt 30 min. nach, trennt die organische Phase ab, wäscht diese zweimal mit Wasser und trocknet über Natriumsulfat. Nach Entfernen der Lösungsmittel im Vakuum wird der Rückstand zweimal aus DMF umkristallisiert. Ausbeute: 21.5 g (47 mmol), 47.6 %; Reinheit: ca. 97 % ig n. ¹H-NMR.

Analog werden folgende Verbindungen dargestellt:

| Bsp. | S | Produkt | Ausbeute |
|---|---|---|---|
| 19 | 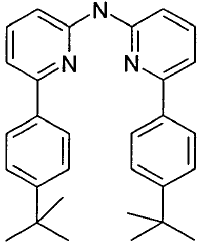 | 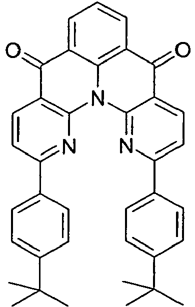 | 51 % |
| | S2 | S19 | |
| 20 | 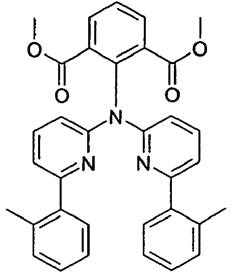 | 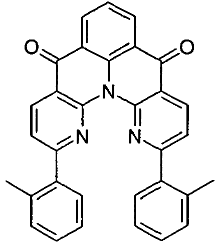 | 37 % |
| | S11 | S20 | |
| 21 | 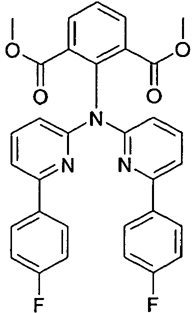 | 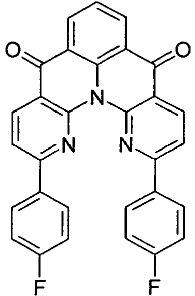 | 44 % |
| | S12 | S21 | |
| 22 | 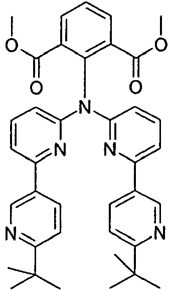 | 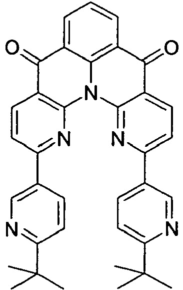 | 23 % |
| | S15 | S22 | |
| 23 | 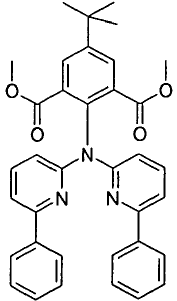 | 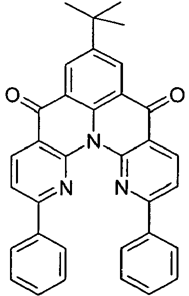 | 48% |
| | S17 | S23 | |

### 24) Bis-3-brom-phenyl-amin S24

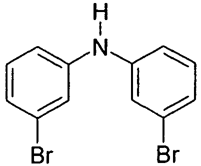

Ein Gemisch aus 235.9 g (200 mmol) 1,3-Dibrombenzol, 50.1 g (50 mmol) Pivaloylamid, 32.6 g (100 mmol) Cäsiumcarbonat, 1.2 g (2 mmol) XanthPhos, 449 mg (2 mmol) Palladium(II)acetat und 500 ml Dioxan wird 8 h bei 100 °C gerührt. Nach Erkalten saugt man von den Salzen ab, wäscht diese zweimal mit je 200 ml Dioxan nach, engt die organische Phase im Vakuum zur Trockene ein, nimmt den Feststoff in 500 ml Ethanol auf, gibt 50 ml 5 N HCl zu und erhitzt 16 h unter Rückfluss. Man entfernt das Ethanol im Vakuum, nimmt den Rückstand in 1000 ml Ethylacetat auf, wäscht die organische Phase einmal mit 300 ml gesättigter Kaliumcarbonatlösung, dreimal mit je 300 ml Wasser und trocknet über Natriumsulfat. Man entfernt das Ethylacetat im Vakuum und bringt den öligen Rückstand durch Zugabe von ca. 200 ml heißem Methanol zur Kristallisation. Ausbeute: 13.4 g (41 mmol), 82.0 %; Reinheit: ca. 95 %ig nach ¹H-NMR.

### 25) 2-[Bis(3-bromphenyl)-amino]iso-phthalsäuredimethylester S25

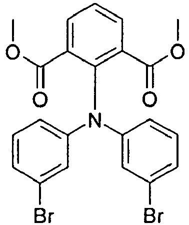

Ein Gemisch aus 16.4 g (50 mmol) S24, 11.7 g (55 mmol) 2-Fluor-isophthalsäure-di-methylester, 6.7 g (60 mmol) Kalium-tert-butylat und 150 ml wasserfreiem DMSO wird 24 h bei 80 °C gerührt. Nach Erkalten gießt man auf 1000 ml Eiswasser, extrahiert fünfmal mit je 200 ml Dichlormethan, wäscht das Dichlormethan dreimal mit 300 ml Wasser, trocknet die organische Phase über Natriumsulfat und entfernt das Dichlormethan im Vakuum. Man rührt den Feststoff einmal mit wenig Methanol aus und trocknet im Vakuum. Ausbeute: 22.3 g (43 mmol), 86.0 %; Reinheit: ca. 95 %ig n. ¹H-NMR.

### 26) 2,12-Dibrom-13b-aza-naphthyo[3,2,1-de]anthacen-5,9-dion S26

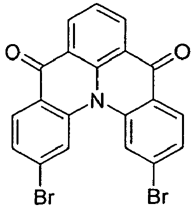

Eine Lösung von 26.0 g (50 mmol) S25 in 300 ml Methansulfonsäure wird langsam auf 100 °C erhitzt und 4 h gerührt. Nach Erkalten gießt man auf 1000 ml Eiswasser, stellt durch Zugabe von NaOH alkalisch, saugt vom ausgefallenen Feststoff ab, wäscht diesen je dreimal mit 100 ml eines Gemischs aus Wasser / EtOH (1:1 vv), dreimal mit je 50 ml EtOH und trocknet im Vakuum. Der so erhaltene Feststoff wird aus DMF / Methanol umkristallisiert. Ausbeute: 12.5 g (27 mmol), 54.9 %; Reinheit: ca. 99 %ig nach ¹H-NMR.

### 27) 2,12-Dibrom-13b-aza-naphthyo[3,2,1-de]anthracen-5,9-bis-spiro-9,9'-bifluoren S27

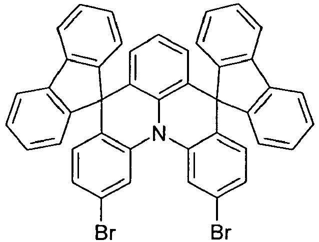

Darstellung analog L7 wobei anstelle von S18 45.5 g (100 mmol) S26 eingesetzt werden und die Reinigung nur durch Umkristallisation erfolgt. Ausbeute: 37.1 g (52 mmol), 52.0 %; Reinheit: ca. 99 % ig n. ¹H-NMR

### 28) 2,12-Dibrom-5,5,9,9-tetrametyl-5H,)H-13b-aza-naphthyo[3,2,1-de]anthracen S28

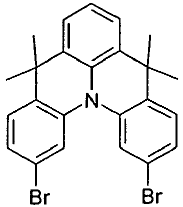

Eine Suspension von 54.2 g (220 mmol) wasserfreiem Cer(III)chlorid und 100 g Glaskugeln (5 mm Durchmesser) in 300 ml THF wird 1 h gerührt. Dann gibt man 51.9 g (100 mmol) S25 portionsweise fest zu und rührt erneut 1 h bei Raumtemperatur nach. Man kühlt die Suspension auf 0°C ab und tropft langsam 600 ml (600 mmol) einer 1 N Methylmagnesiumchlorid in THF zu, so dass die Temperatur 5 °C nicht übersteigt. Nach vollendeter Zugabe lässt man auf Raumtemperatur erwärmen und rührt 16 h nach. Man kühlt die Reaktionsmischung erneut auf 0 °C ab, hydrolysiert vorsichtig (exotherm!, Gasentwicklung!) durch Zugabe von 1000 ml 1 N Essigsäure, gibt 1000 ml Ethylacetat zu, trennt die organische Phase ab, extrahiert die wässrige Phase dreimal mit je 200 ml Ethylacetat, wäscht die vereinigten organischen Phasen zweimal mit 300 ml Wasser, einmal mit 500 ml gesättigter Kochsalzlösung, trocknet über Natriumsulfat und entfernt dann das Lösungsmittel im Vakuum. Man nimmt den Rückstand in 300 ml Dichlormethan auf, und tropft die Lösung in ein gut gerührtes, auf 0°C gekühltes Gemisch aus 500 ml Dichlormethan, 100 g Polyphosphorsäure und 65 ml (1 mol) Methansulfonsäure. Nach beendeter Zugabe lässt man unter Rühren auf Raumtemperatur erwärmen, rührt 2 h nach, gießt dann auf 2000 ml Eiswasser, trennt die organische Phase ab, wäscht diese dreimal mit je 200 ml Wasser, trocknet über Natriumsulfat und entfernt dann das Lösungsmittel im Vakuum. Der Rückstand wird zweimal aus DMF umkristallisiert. Ausbeute: 33.0 g (68 mmol), 68.3 %; Reinheit: ca. 95 % ig n. ¹H-NMR.

### B: Synthese von Liganden L:

### 29) 2,12-Diphenyl-5H,9H-1,13,13b-triaza-naphtho[3,2,1-de]anthracen L1

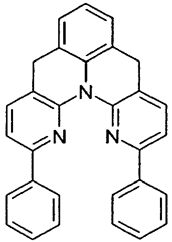

Ein Gemisch aus 45.2 g (100 mmol) S18, 9.6 ml (300 mmol) Hydrazinhydrat und 300 ml Triethylenglykol wird am Wasserabscheider 20 h auf 180 °C erhitzt. Nach Erkalten verdünnt man mit 100 ml Wasser, saugt vom ausgefallen Feststoff ab, wäscht diesen je dreimal mit 100 ml eines Gemischs aus Wasser / EtOH (1:1 w), dreimal mit 100 ml EtOH und trocknet im Vakuum. Der so erhaltene Feststoff wird aus DMF umkristallisiert und anschließend durch fraktionierte Sublimation (p ca. 10⁻⁵ mbar, T ca. 280 °C) von leichtflüchtigen und nicht flüchtigen Komponenten bereit. Ausbeute: 25.3 g (60 mmol), 59.7 %; Reinheit: ca. 99 %ig nach ¹H-NMR.

Analog werden folgende Verbindungen dargestellt:

| Bsp. | S | Produkt | Ausbeute |
|---|---|---|---|
| 30 | 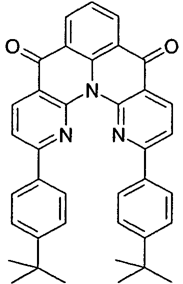 | 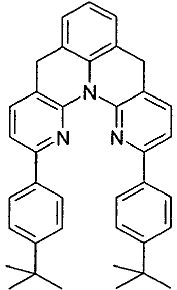 | 60 % |
| | S19 | L2 | |
| 31 | 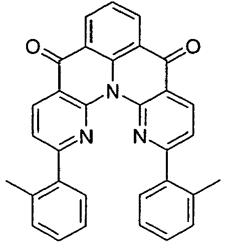 | 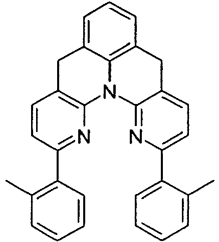 | 51 % |
| | S20 | L3 | |
| 32 | 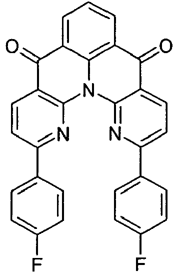 | 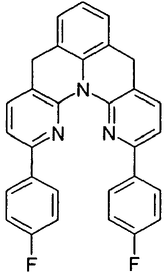 | 28 % |
| | S21 | L4 | |
| 33 | 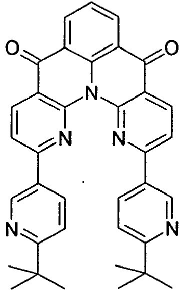 | 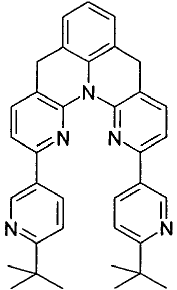 | 64 % |
| | S22 | L5 | |
| 34 | 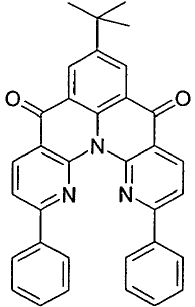 | 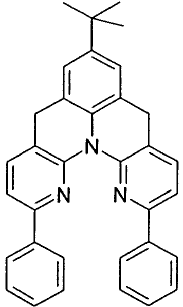 | 58 % |
| | S23 | L6 | |

### 35) 2,12-Diphenyl-5,9-bis-(9,9'-spiro-bifluorenyl)-1,13,13b-triazanaphtho[3,2,1-de]anthracen L7

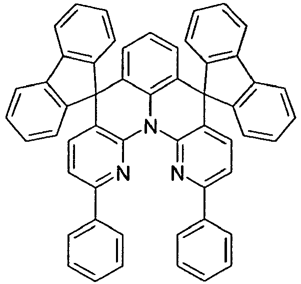

Aus einem Gemisch aus 51.3 g (230 mmol) 2-Brombiphenyl, 1.6 ml (20 mmol) 1,2-Dichlorethan, 400 ml THF, 500 ml Toluol und 50 ml 1,2-Dimethoxyethan und 4.9 g (200 mmol) mit lod aktivierten Magnesiumspänen wird das entsprechende Grignardreagenz dargestellt. Gegebenenfalls muss bei der Zugabe der Bromidlösung mit einem Ölbad begleitgeheizt, bzw. bis zum vollständigen Umsatz des Magnesiums unter Rückfluss erhitzt werden. Nach Abkühlen des Grignardreagenz auf ca. 50 °C gibt man 45.1 g (100 mmol) S18 portionsweise fest zu und rührt dann noch 5 h bei 50 °C nach. Nach Erkalten engt man die Reaktionsmischung im Vakuum zur Trockene ein, nimmt sie in 1000 ml Eisessig auf, gibt 10 ml konz. Schwefelsäure zu, erhitzt unter Rückfluss und tropft dann 19 ml (200 mmol) Essigsäureanhydrid zu. Nach beendeter Zugabe rührt man noch 2 h unter Rücklfluss nach, lässt dann unter Rühren erkalten, saugt von ausgefallenen Feststoff ab, wäscht diesen einmal mit 300 ml Eisessig und dann fünfmal mit je 100 ml Ethanol. Der so erhaltene Feststoff wird aus DMF umkristallisiert und anschließend durch fraktionierte Sublimation (p ca. 10⁻⁵ mbar, T ca. 280 °C) von leichtflüchtigen und nicht flüchtigen Komponenten bereit. Ausbeute: 45.9 g (63 mmol), 63.4 %; Reinheit: ca. 99 %ig nach ¹H-NMR.

Analog werden folgende Verbindungen dargestellt:

| Bsp. | S | Produkt | Ausbeute |
|---|---|---|---|
| 36 | 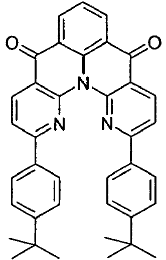 | 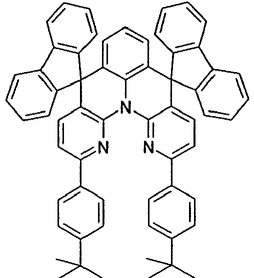 | 58% |
| | S19 | L8 | |
| 37 | 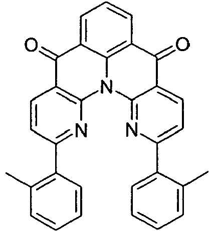 | 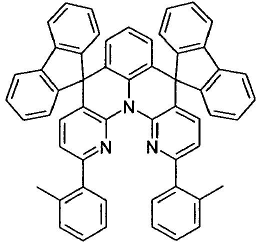 | 41 % |
| | S20 | L9 | |
| 38 | 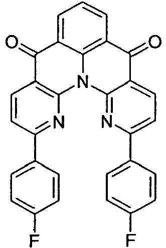 | 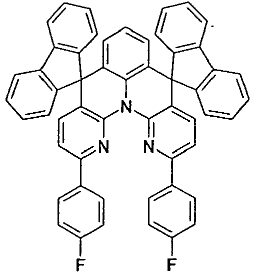 | 55% |
| | S21 | L10 | |
| 39 | 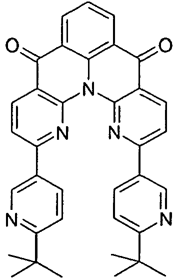 | 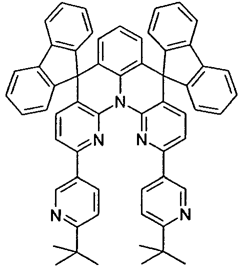 | 32% |
| | S22 | L11 | |
| 40 | 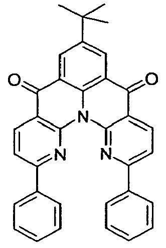 | 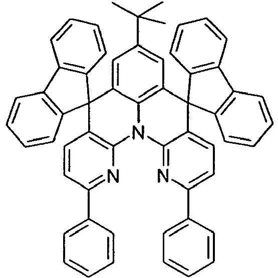 | 46% |
| | S23 | L12 | |

### 41) 5,5,9,9-Tetramethyl-2,12-diphenyl-5H,9H-1,13,13b-triaza-naphtho[3,2,1-de]anthracen L13

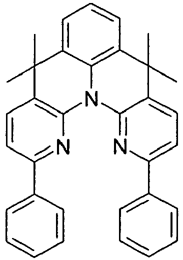

Eine Suspension von 54.2 g (220 mmol) wasserfreiem Cer(III)chlorid und 100 g Glaskugeln (5 mm Durchmesser) in 400 ml THF wird 1 h gerührt. Dann gibt man 51.6 g (100 mmol) S9 portionsweise fest zu und rührt erneut 1 h bei Raumtemperatur nach. Man kühlt die Suspension auf 0 °C ab und tropft langsam 600 ml (600 mmol) einer 1 N Methylmagnesiumchlorid in THF zu, so dass die Temperatur 5 °C nicht übersteigt. Nach vollendeter Zugabe lässt man auf Raumtemperatur erwärmen und rührt 16 h nach. Man kühlt die Reaktionsmischung erneut auf 0 °C ab, hydrolysiert vorsichtig (exotherm!, Gasentwicklung!) durch Zugabe von 650 ml 1 N Essigsäure, gibt 1000 ml Ethylacetat zu, trennt die organische Phase ab, extrahiert die wässrige Phase dreimal mit je 200 ml Ethylacetat, wäscht die vereinigten organischen Phasen zweimal mit 300 ml Wasser und einmal mit 500 ml gesättigter Kochsalz-Lösung, trocknet über Natriumsulfat und entfernt dann das Lösungsmittel im Vakuum. Man nimmt den Rückstand in 300 ml Methansulfonsäure auf, gibt 100 g Polyphosphorsäure zu, erhitzt langsam auf 120 °C und rührt 4 h nach. Nach Erkalten gießt man auf 1000 ml Eiswasser, stellt durch Zugabe von NaOH alkalisch, saugt vom ausgefallenen Feststoff ab, wäscht diesen je dreimal mit 200 ml eines Gemischs aus Wasser / EtOH (1:1 vv), dreimal mit 100 ml EtOH und trocknet im Vakuum. Der so erhaltene Feststoff wird aus DMF umkristallisiert und anschließend durch fraktionierte Sublimation (p ca. 10⁻⁵ mbar, T ca. 280 °C) von leichtflüchtigen und nicht flüchtigen Komponenten bereit. Ausbeute: 14.9 g (31 mmol), 31.1 %; Reinheit: ca. 99 %ig nach ¹H-NMR.

Analog werden folgende Verbindungen dargestellt:

| Bsp. | S | Produkt | Ausbeute |
|---|---|---|---|
| 42 | 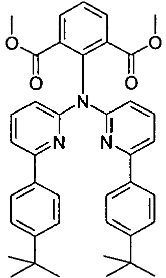 | 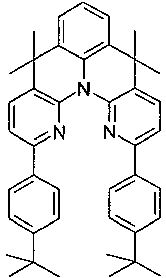 | 33 % |
| | S10 | L14 | |
| 43 | 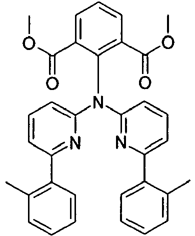 | 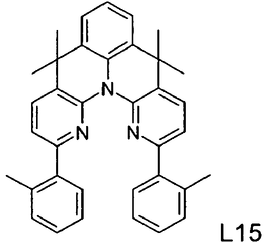 | 27% |
| | S11 | L15 | |
| 44 | 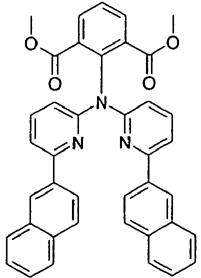 | 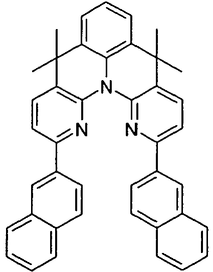 | 24 % |
| | S13 | L15 | |
| 45 | 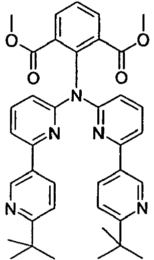 | 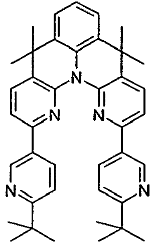 | 35% |
| | S15 | L16 | |
| 46 | 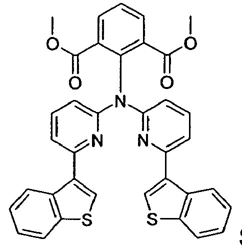 | 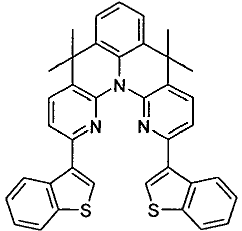 | 13% |
| | S16 | L17 | |
| 47 | 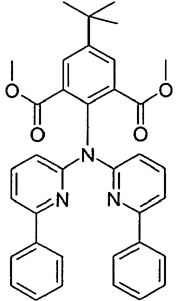 | 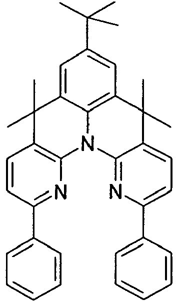 | 30% |
| | S17 | L18 | |

### 48) 2,12-di-pyridin-2-yl-5H,9H-5,9-bis-spiro(9,9'-fluorenyl)-13b-aza-naphtho[3,2,1-de]anthracen L19

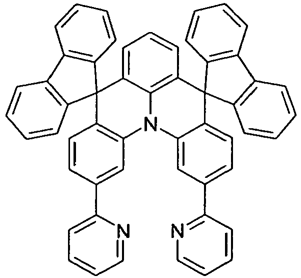

Ein Gemisch aus 36.4 g (50 mmol) S27, 30.8 g (150 mmol) 2-(4,4,5,5-Tetramethyl-1,3,2-dioxaborolan-2-yl)pyridin [874186-98-8], 32.8 g (100 mmol) Cäsiumcarbonat, 554 mg (1 mmol) dppf, 224 mg (1 mmol) Palladium(II)acetat, 198 mg (2 mmol) Kupfer(I)chlorid und 300 ml DMF wird 16 h auf 100 °C erhitzt. Nach Erkalten saugt man von den ausgefallenen Salzen ab, wäscht mit 200 ml DMF nach, entfernt das DMF im Vakuum, nimmt den Rückstand in 500 ml Ethylacetat auf, wäscht die organische Phase dreimal mit 300 ml Wasser und einmal mit 500 ml gesättigter Kochsalzlösung, trocknet über Natriumsulfat und entfernt dann das Lösungsmittel im Vakuum. Der so erhaltene Feststoff wird aus DMF umkristallisiert und anschließend durch fraktionierte Sublimation (p ca. 10⁻⁵ mbar, T ca. 280 °C) von leichtflüchtigen und nicht flüchtigen Komponenten bereit. Ausbeute: 22.3 g (31 mmol), 61.6 %; Reinheit: ca. 99 %ig nach ¹H-NMR.

Analog werden folgende Verbindungen dargestellt:

| Bsp. | Boronsäureester | Produkt | Ausbeute |
|---|---|---|---|
| 49 | 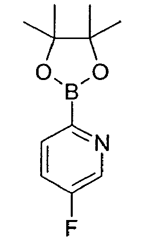 | 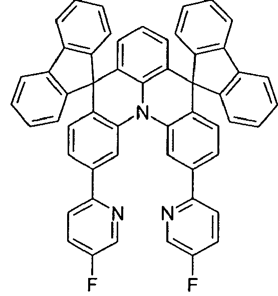 | 76 % |
| | [791819-04-0] | L20 | |
| 50 | 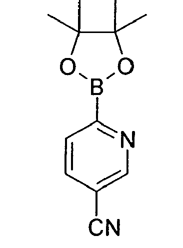 | 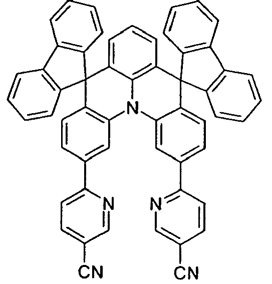 | 68 % |
| | [1073353-83-9] | L21 | |

### 51) 5,5,9,9-Tetramethyl-2,12-di-pyridin-2-yl-5H,9H-13b-aza-naphtho[3,2,1-de]anthracen L22

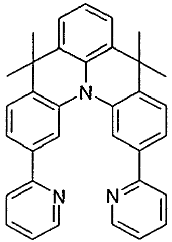

Durchführung analog L19, wobei anstelle von S27 24.2 g (50 mmol) S28 verwendet werden. Ausbeute: 17.2 g (36 mmol), 71.7 %; Reinheit: ca. 99 %ig nach ¹H-NMR.

Analog werden folgende Verbindungen dargestellt:

| Bsp. | Boronsäureester | Produkt | Ausbeute |
|---|---|---|---|
| 52 | 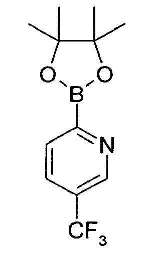 | 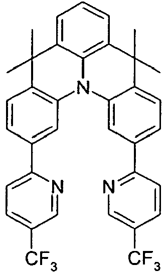 | 63% |
| | [1101205-23-5] | L23 | |
| 53 | 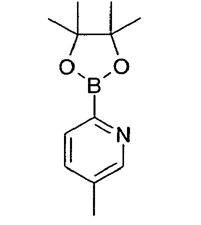 | 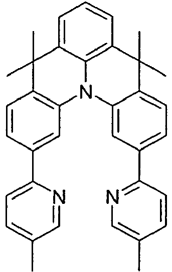 | 70% |
| | [11012505-22-4] | L24 | |

### 54) 5,5,9,9-Tetramethyl-2,12-di-pyridin-2-yl-5H,9H-13b-aza-naphtho[3,2,1-de]anthracen L25

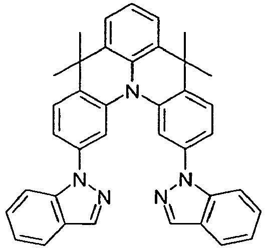

Ein Gemisch aus 48.3 g (100 mmol) S28, 29.5 g (250 mmol) 3aH-Indazol [271-38-6], 84.9 g (400 mmol) Trikaliumphosphat, 1.9 g (10 mmol) Kupfer-(I)iodid, 4.6 g (40 mmol) trans-1,2-Diaminocyclohexan, 100 g Glaskugeln (5 mm Durchmesser) und 500 ml Toluol wird 20 h unter Rückfluss erhitzt. Man saugt noch warm von den Salzen und Glaskugeln ab, wäscht diese zweimal mit je 200 ml Toluol nach, wäscht die vereinigten organischen Phasen zweimal mit je 500 ml Wasser, einmal mit 500 ml gesättigter Kochsalzlösung und entfernt das Toluol im Vakuum. Der so erhaltene Feststoff wird aus DMF / Ethanol umkristallisiert und anschließend durch fraktionierte Sublimation (p ca. 10⁻⁵ mbar, T ca. 290 °C) von leichtflüchtigen und nicht flüchtigen Komponenten befreit. Ausbeute: 30.7 g (55 mmol), 55.0 %; Reinheit: ca. 99 %ig nach ¹H-NMR.

Analog wird die folgende Verbindung dargestellt:

| Bsp. | Indazol | Produkt | Ausbeute |
|---|---|---|---|
| 55 | 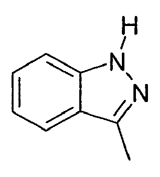 | 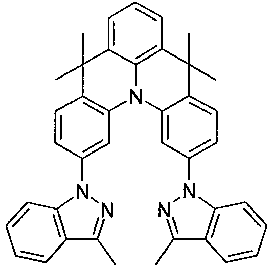 | 46% |
| | [3176-62-3] | L26 | |

### C: Synthese von Komplexen

### Variante A:

Ein Gemisch aus 10 mmol Kalium-tetrachloroplatinat, 10 mmol des Liganden L und 50 mmol Lithiumacetat (wasserfrei) in 100 ml Eisessig wird 60 h unter Rückfluss erhitzt. Nach tropfenweiser Zugabe von 100 ml Methanol und 100 ml Wasser zur erkalteten Reaktionsmischung wird vom Feststoff abgesaugt, dieser wird fünfmal mit je 25 ml Methanol gewaschen und im Vakuum getrocknet. Der so erhaltene Feststoff wird in einem Heißextraktor auf einem 3 cm hohen Celite-Bett (Alox, basisch, Aktivitätsstufe 1) platziert und dann mit dem angegebenen Extraktionsmittel (Vorlagemenge ca. 300 ml) extrahiert. Nach beendeter Extraktion wird das Extraktionsmittel im Vakuum auf ca. 100 ml eingeengt. Metallkomplexe, die im Extraktionsmittel eine zu gute Löslichkeit aufweisen, werden durch Zutropfen von 200 ml Methanol zur Kristallisation gebracht. Der Feststoff der so erhaltenen Suspension wird abgesaugt, einmal mit ca. 50 ml Methanol gewaschen und getrocknet. Nach Trocknen wird die Reinheit des Metallkomplexes mittels NMR und/oder HPLC bestimmt. Liegt die Reinheit unter 99.5 % wird der Heißextraktionsschritt wiederholt; ist eine Reinheit von 99.5 - 99.9 % erreicht, wird der Pt-Komplex sublimiert. Die Sublimation erfolgt im Hochvakuum (p ca. 10⁻⁶ mbar) im Temperaturbereich von ca. 350 bis ca. 390 °C, wobei die Sublimation bevorzugt in Form einer fraktionierten Sublimation durchgeführt wird.

### Variante B:

Ein Gemisch aus 10 mmol Bis(benzonitril)-dichloro-platin(II) und 10 mmol des Liganden L in 50 ml Benzonitril wird 24 h unter Rückfluss erhitzt. Nach tropfenweiser Zugabe von 100 ml Methanol zur erkalteten Reaktionsmischung wird vom Feststoff abgesaugt, dieser wird fünfmal mit je 25 ml Methanol gewaschen und im Vakuum getrocknet. Restliche Aufarbeitung wie bei Variante A beschrieben.

| **Bsp.** | **Ligand L** | **Pt-Komplex** | **Variante Extraktionsmittel** | **Ausbeute** |
|---|---|---|---|---|
| 56 | L1 | 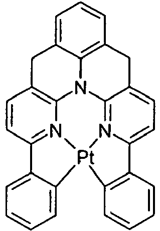 | A | 32% |
| | | | Toluol | |
| | | PtL1 | | |
| 57 | L2 | PtL2 | B | 28% |
| | | | Toluol | |
| 58 | L3 | PtL3 | A | 33 % |
| | | | Toluol | |
| 59 | L4 | PtL4 | A | 30% |
| | | | Toluol | |
| 60 | L5 | PtL5 | A | 21 % |
| | | | Toluol | |
| 61 | L6 | PtL6 | A | 35% |
| | | | Toluol | |
| 62 | L7 | PtL7 | A | 25% |
| | | | o-Xylol | |
| 63 | L8 | PtL8 | A | 28% |
| | | | o-Xylol | |
| 64 | L9 | PtL9 | A | 20% |
| | | | o-Xylol | |
| 65 | L10 | PtL10 | A | 27% |
| | | | o-Xylol | |
| 66 | L11 | PtL11 | A | 17% |
| | | | o-Xylol | |
| 67 | L12 | PtL12 | A | 32% |
| | | | o-Xylol | |
| 68 | L13 | PtL13 | A | 30% |
| | | | Toluol | |
| 69 | L14 | PtL14 | B | 30% |
| | | | Toluol | |
| 70 | L15 | PtL15 | A | 28% |
| | | | Toluol | |
| 71 | L16 | PtL16 | A | 13% |
| | | | Toluol | |
| 72 | L17 | PtL17 | A | 24% |
| | | | Toluol | |
| 73 | L18 | PtL18 | A | 26% |
| | | | Toluol | |
| 74 | L19 | PtL19 | A | 34 % |
| | | | o-Xylol | |
| 75 | L20 | PtL20 | A | 33% |
| | | | o-Xylol | |
| 76 | L21 | PtL21 | A | 30% |
| | | | o-Xylol | |
| 77 | L22 | PtL22 | A | 27 % |
| | | | Toluol | |
| 78 | L23 | PtL23 | A | 25 % |
| | | | Toluol | |
| 79 | L24 | PtL24 | A | 27 % |
| | | | Toluol | |
| 80 | L25 | PtL25 | A | 21 % |
| | | | Toluol | |
| 81 | L26 | PtL26 | A | 19% |
| | | | Toluol | |

### Beispiel: Herstellung der OLEDs

Die Herstellung von erfindungsgemäßen OLEDs sowie OLEDs nach dem Stand der Technik erfolgt nach einem allgemeinen Verfahren gemäß WO 2004/058911, das auf die hier beschriebenen Gegebenheiten (Schichtdickenvariation, verwendete Materialien) angepasst wird.

In den folgenden Beispielen (siehe Tabellen 1 und 2) werden die Ergebnisse verschiedener OLEDs vorgestellt. Glasplättchen, die mit strukturiertem ITO (Indium Zinn Oxid) der Dicke 150 nm beschichtet sind, werden zur verbesserten Prozessierung mit 20 nm PEDOT beschichtet (Poly(3,4-ethylendioxy-2,5-thiophen), aus Wasser aufgeschleudert; bezogen von H. C. Starck, Goslar, Deutschland). Diese beschichteten Glasplättchen bilden die Substrate, auf welche die OLEDs aufgebracht werden. Die OLEDs haben prinzipiell folgenden Schichtaufbau: Substrat / optionale Lochinjektionsschicht (HIL1) / optionale Lochinjektionsschicht (HIL2) / Lochtransportschicht (HTL) / Elektronenblockerschicht (EBL) / Emissionsschicht (EML) / optionale Lochblockierschicht (HBL) / Elektronentransportschicht (ETL) und abschließend eine Kathode. Die Kathode wird durch eine 100 nm dicke Aluminiumschicht gebildet

Zunächst werden vakuumprozessierte OLEDs beschrieben. Hierfür werden alle Materialien in einer Vakuumkammer thermisch aufgedampft. Dabei besteht die Emissionsschicht immer aus mindestens einem Matrix-material (Hostmaterial, Wirtsmaterial) und einem emittierenden Dotierstoff (Dotand, Emitter), der dem Matrixmaterial bzw. den Matrixmaterialien durch Coverdampfung in einem bestimmten Volumenanteil beigemischt wird. Eine Angabe wie M3:M2:Ir(L1)₃ (55%:35%:10%) bedeutet hierbei, dass das Material M3 in einem Volumenanteil von 55%, M2 in einem Anteil von 35% und Ir(L1)₃ in einem Anteil von 10% in der Schicht vorliegt. Analog kann auch die Elektronentransportschicht aus einer Mischung zweier Materialien bestehen. Der genaue Aufbau der OLEDs ist Tabelle 1 zu entnehmen. Die zur Herstellung der OLEDs verwendeten Materialien sind in Tabelle 3 gezeigt.

Die OLEDs werden standardmäßig charakterisiert. Hierfür werden die Elektrolumineszenzspektren, die Stromeffizienz (gemessen in cd/A) und die Spannung (gemessen bei 1000 cd/m² in V) bestimmt aus Strom-Spannungs-Helligkeits-Kennlinien (IUL-Kennlinien). Für ausgewählte Versuche wird die Lebensdauer bestimmt. Als Lebensdauer wird die Zeit definiert, nach der die Leuchtdichte von einer bestimmten Startleuchtdichte aus auf einen gewissen Anteil abgesunken ist. Die Angabe LD50 bedeutet, dass es sich bei der genannten Lebensdauer um die Zeit handelt, bei der die Leuchtdichte auf 50% der Startleuchtdichte abgefallen ist, also von z.B. 4000 cd/m² auf 2000 cd/m². Je nach Emissionsfarbe wurden unterschiedliche Starthelligkeiten gewählt. Die Werte für die Lebensdauer können mit Hilfe dem Fachmann bekannten Umrechnungsformeln auf eine Angabe für andere Startleuchtdichten umgerechnet werden. Hierbei ist die Lebensdauer für eine Startleuchtdichte von 1000 cd/m² eine übliche Angabe.

### Verwendung von erfindungsgemäßen Verbindungen als Emittermaterialien in phosphoreszierenden OLEDs

Die erfindungsgemäßen Verbindungen lassen sich unter anderem als phosphoreszierende Emittermaterialien in der Emissionsschicht in OLEDs einsetzen. Als Vergleich gemäß dem Stand der Technik werden die Verbindungen Pt(Ref1) und Pt(Ref2) verwendet. Die Ergebnisse der OLEDs sind in Tabelle 2 zusammengefasst. Bei den OLEDs zeigt sich hier, dass die erfindungsgemäßen Materialien zu effizienten roten und grün emittierenden OLEDs führen.

**Tabelle 1: Aufbau der OLEDs**

| Bsp. | HIL1 | HIL2 | HTL | EML | HBL | ETL |
|---|---|---|---|---|---|---|
| | Dicke | Dicke | Dicke | Dicke | Dicke | Dicke |
| 82 Ref | HIM1 | HIM2 | HTM | M1:M2:Pt(Ref1) | M1 | ETM1:LiQ |
| | 70 nm | 5 nm | 90 nm | (80%:15%:5%) | 10 nm | (50%:50%) |
| | | | | 40 nm | | 30 nm |
| 83 | HIM1 | HIM2 | HTM | M1:M2:PtL1 | M1 | ETM1:LiQ |
| | 70 nm | 5 nm | 90 nm | (80%:15%:5%) | 10 nm | (50%:50%) |
| | | | | 40 nm | | 30 nm |
| 84 | HIM1 | HIM2 | HTM | M1:M2:PtL2 | M1 | ETM1:LiQ |
| | 70 nm | 5 nm | 90 nm | (80%:15%:5%) | 10 nm | (50%:50%) |
| | | | | 40 nm | | 30 nm |
| 85 | HIM1 | HIM2 | HTM | M1:M2:PtL3 | M1 | ETM1:LiQ |
| | 70 nm | 5nm | 90 nm | (80%:15%:5%) | 10 nm | (50%:50%) |
| | | | | 40 nm | | 30 nm |
| 86 | HIM1 | HIM2 | HTM | M1:M2:L4 | M1 | ETM1:LiQ |
| | 70 nm | 5 nm | 90 nm | (80%:15%:5%) | 10 nm | (50%:50%) |
| | | | | 40 nm | | 30 nm |
| 87 | HIM1 | HIM2 | HTM | M1:M2:L5 | M1 | ETM1:LiQ |
| | 70 nm | 5 nm | 90 nm | (80%:15%:5%) | 10 nm | (50%:50%) |
| | | | | 40 nm | | 30 nm |
| 88 | HIM1 | HIM2 | HTM | M1:M2:L6 | M1 | ETM1:LiQ |
| | 70 nm | 5nm | 90 nm | (80%:15%:5%) | 10 nm | (50%:50%) |
| | | | | 40 nm | | 30 nm |
| 89 | HIM1 | HIM2 | HTM | M1:M2:L7 | M1 | ETM1:LiQ |
| | 70 nm | 5 nm | 90 nm | (80%:15%:5%) | 10 nm | (50%:50%) |
| | | | | 40 nm | | 30 nm |
| 90 | HIM1 | HIM2 | HTM | M1:M2:L8 | M1 | ETM1:LiQ |
| | 70 nm | 5 nm | 90 nm | (80%:15%:5%) | 10 nm | (50%:50%) |
| | | | | 40 nm | | 30 nm |
| 91 | HIM1 | HIM2 | HTM | M1:M2:L9 | M1 | ETM1:LiQ |
| | 70 nm | 5 nm | 90 nm | (80%:15%:5%) | 10 nm | (50%:50%) |
| | | | | 40 nm | | 30 nm |
| 92 | HIM1 | HIM2 | HTM | M1:M2:L10 | M1 | ETM1:LiQ |
| | 70 nm | 5 nm | 90 nm | (80%:15%:5%) | 10 nm | (50%:50%) |
| | | | | 40 nm | | 30 nm |
| 93 | HIM1 | HIM2 | HTM | M1:M2:L11 | M1 | ETM1:LiQ |
| | 70 nm | 5 nm | 90 nm | (80%:15%:5%) | 10 nm | (50%:50%) |
| | | | | 40 nm | | 30 nm |
| 94 | HIM1 | HIM2 | HTM | M1:M2:Pt(Ref1)₃ | M1 | ETM1:LiQ |
| | 70 nm | 5nm | 90 nm | (80%:15%:5%) | 10 nm | (50%:50%) |
| | | | | 40 nm | | 30 nm |
| 95 | HIM1 | HIM2 | HTM | M1:M2:L12 | M1 | ETM1:LiQ |
| | 70 nm | 5 nm | 90 nm | (80%:15%:5%) | 10 nm | (50%:50%) |
| | | | | 40 nm | | 30 nm |
| 96 | HIM1 | HIM2 | HTM | M1:M2:L13 | M1 | ETM1:LiQ |
| | 70 nm | 5 nm | 90 nm | (80%:15%:5%) | 10 nm | (50%:50%) |
| | | | | 40 nm | | 30 nm |
| 97 | HIM1 | HIM2 | HTM | M1:M2:L14 | M1 | ETM1:LiQ |
| | 70 nm | 5 nm | 90 nm | (80%:15%:5%) | 10 nm | (50%:50%) |
| | | | | 40 nm | | 30 nm |
| 98 | HIM1 | HIM2 | HTM | M1:M2:L15 | M1 | ETM1:LiQ |
| | 70 nm | 5 nm | 90 nm | (80%:15%:5%) | 10 nm | (50%:50%) |
| | | | | 40 nm | | 30 nm |
| 99 | HIM1 | HIM2 | HTM | M1:M2:L16 | M1 | ETM1:LiQ |
| | 70 nm | 5nm | 90 nm | (80%:15%:5%) | 10 nm | (50%:50%) |
| | | | | 40 nm | | 30 nm |
| 100 | HIM1 | HIM2 | HTM | M1:M2:L17 | M1 | ETM1:LiQ |
| | 70 nm | 5 nm | 90 nm | (80%:15%:5%) | 10 nm | (50%:50%) |
| | | | | 40 nm | | 30 nm |
| 101 | HIM1 | HIM2 | HTM | M1:M2:L18 | M1 | ETM1:LiQ |
| | 70 nm | 5 nm | 90 nm | (80%:15%:5%) | 10 nm | (50%:50%) |
| | | | | 40 nm | | 30 nm |
| 102 | HIM1 | HIM2 | HTM | M3:Pt(Ref₂)₃ | ETM1 | ETM1:LiQ |
| Ref. | 80 nm | 10 nm | 20 nm | (93%:7%) | 5 nm | (50%:50%) |
| | | | | 40 nm | | 25 nm |
| 103 | HIM1 | HIM2 | HTM | M3:PtL19 | ETM1 | ETM1:LiQ |
| | 80 nm | 10 nm | 20 nm | (93%:7%) | 5 nm | (50%:50%) |
| | | | | 40 nm | | 25 nm |
| 104 | HIM1 | HIM2 | HTM | M3:PtL20 | ETM1 | ETM1:LiQ |
| | 80 nm | 10 nm | 20 nm | (93%:7%) | 5 nm | (50%:50%) |
| | | | | 40 nm | | 25 nm |
| 105 | HIM1 | HIM2 | HTM | M3:PtL21 | ETM1 | ETM1:LiQ |
| | 80 nm | 10 nm | 20 nm | (93%:7%) | 5 nm | (50%:50%) |
| | | | | 40 nm | | 25 nm |
| 106 | HIM1 | HIM2 | HTM | M3:PtL22 | ETM1 | ETM1:LiQ |
| | 80 nm | 10 nm | 20 nm | (93%:7%) | 5 nm | (50%:50%) |
| | | | | 40 nm | | 25 nm |
| 107 | HIM1 | HIM2 | HTM | M3:PtL23 | ETM1 | ETM1:LiQ |
| | 80 nm | 10 nm | 20 nm | (93%:7%) | 5 nm | (50%:50%) |
| | | | | 40 nm | | 25 nm |
| 108 | HIM1 | HIM2 | HTM | M3:PtL24 | ETM1 | ETM1:LiQ |
| | 80 nm | 10 nm | 20 nm | (93%:7%) | 5 nm | (50%:50%) |
| | | | | 40 nm | | 25 nm |
| 109 | HIM1 | HIM2 | HTM | M1:M2:PtL25 | ETM1 | ETM1:LiQ |
| | 80 nm | 10 nm | 70 nm | (70%:25%:5%) | 5 nm | (70%:30%) |
| | | | | 40 nm | | 25 nm |
| 110 | HIM1 | HIM2 | HTM | M1:M2:PtL26 | ETM1 | ETM1:LiQ |
| | 80 nm | 10 nm | 70 nm | (70%:25%:5%) | 5 nm | (70%:30%) |
| | | | | 40 nm | | 25 nm |

**Tabelle 2: Verwendung von erfindungsgemäßen Verbindungen als Emitter in phosphoreszenten OLEDs**

| Bsp. | EQE[%] bei 1000 cd/m² | Spannung(V) bei 1000 cd/m² | CIE x/y bei 1000 cd/m² | LD50 (h) bei 1000 cd/m² |
|---|---|---|---|---|
| 82 Ref | 16.5 | 3.8 | 0.35/0.62 | 24000 |
| 83 | 17.6 | 3.7 | 0.35/0.63 | 33000 |
| 84 | 17.8 | 3.8 | 0.35/0.62 | 38000 |
| 85 | 16.9 | 3.6 | 0.35/0.62 | 28000 |
| 86 | 17.6 | 3.8 | 0.23/0.52 | 10000 |
| 87 | 16.8 | 3.9 | 0.21/0.47 | 7000 |
| 88 | 17.6 | 3.6 | 0.35/0.62 | 36000 |
| 89 | 17.0 | 3.7 | 0.35/0.61 | 28000 |
| 90 | 18.0 | 4.1 | 0.35/0.62 | 27000 |
| 91 | 18.2 | 4.3 | 0.35/0.62 | 30000 |
| 92 | 17.7 | 4.1 | 0.34/0.61 | 32000 |
| 93 | 16.0 | 4.2 | 0.23/0.52 | 8000 |
| 94 | 15.7 | 4.5 | 0.23/0.49 | 6000 |
| 95 | 17.8 | 4.6 | 0.35/0.62 | 29000 |
| 96 | 16.9 | 3.8 | 0.35/0.62 | 35000 |
| 97 | 16.7 | 3.7 | 0.35/0.62 | 33000 |
| 98 | 17.0 | 3.6 | 0.47/0.52 | 24000 |
| 99 | 15.5 | 3.5 | 0.23/0.48 | 8000 |
| 100 | 16.0 | 3.9 | 0.54/0.45 | 19000 |
| 101 | 16.9 | 3.9 | 0.35/0.62 | 35000 |
| 102 Ref. | 13.3 | 4.6 | 0.66/0.34 | 29000 |
| 103 | 14.6 | 4.7 | 0.67/0.33 | 35000 |
| 104 | 14.1 | 3.9 | 0.68/0.31 | 30000 |
| 105 | 14.8 | 4.2 | 0.63/0.35 | 24000 |
| 106 | 14.5 | 4.2 | 0.67/0.33 | 34000 |
| 107 | 13.7 | 3.8 | 0.63/0.35 | 8000 |
| 108 | 14.9 | 4.5 | 0.67/0.33 | 34000 |
| 109 | 11.9 | 4.8 | 0.22/0.49 | 5000 |
| 110 | 12.4 | 4.7 | 0.22/0.50 | 7000 |

**Tabelle 3: Strukturformeln der verwendeten Materialien**

| | |
|---|---|
| 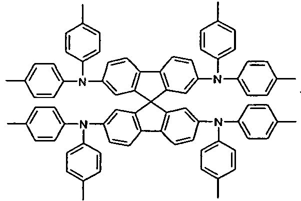 | 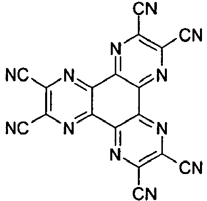 |
| HIL1 | HIL2 |
| 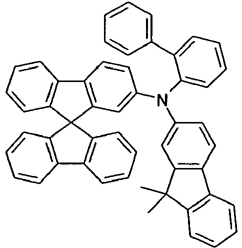 | 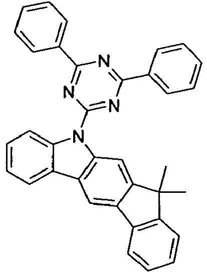 |
| HTM | M1 |
| 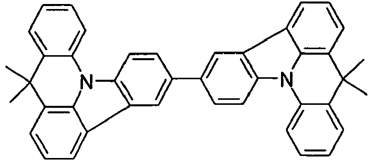 | 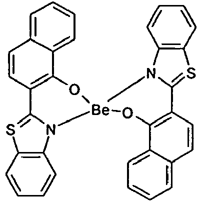 |
| M2 | M3 |
| 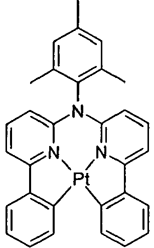 | 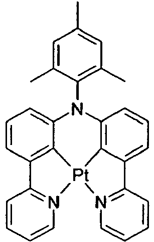 |
| Pt(Ref1) | Pt(Ref2) |
| 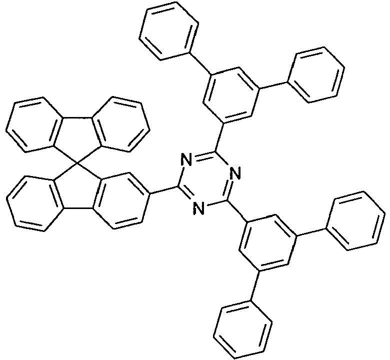 | 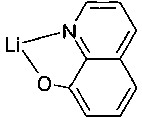 |
| ETM1 | LiQ |

### Beispiel 111) Synthese von 2,12-Dibrom-13b-aza-naphthyro[3,2,1-de]anthracen-5,9-bis-spiro-9,9'-dibenzopyran (Synthon S29)

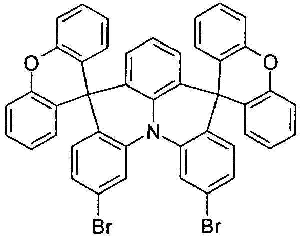

Darstellung analog L7, wobei anstelle von 51.3 g (230 mmol) 2-Brom-biphenyl 57.3 g (230 mmol) 2-Bromphenyl-phenylether und anstelle von S18 45.5 g (100 mmol) S26 eingesetzt werden und die Reinigung nur durch Umkristallisation erfolgt. Ausbeute: 35.0 g (46 mmol), 46.2 %; Reinheit: ca. 99 % ig n. ¹H-NMR

### Beispiel 112) Synthese von 2,12-Diphenyl-5,9-bis-(9,9'-spiro-dibenzo-pyranyl)-1,13,13b-triaza-naphtho[3,2,1-de]anthracen (Ligand L27)

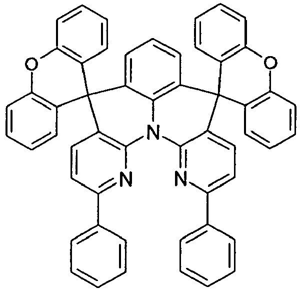

Durchführung analog Beispiel 35, wobei anstelle von 51.3 g (230 mmol) 2-Brombiphenyl 57.3 g (230 mmol) 2-Bromphenyl-phenylether eingesetzt werden. Ausbeute: 49.9 g (66 mmol), 66.0 %; Reinheit: ca. 99 %ig nach ¹H-NMR.

### Beispiel 113) 2,12-Di-pyridin-2-yl-5H,9H-5,9-bis-spiro(9,9'-fluorenyl)-13b-aza-naphtho[3,2,1-de]anthracen (Ligand L28)

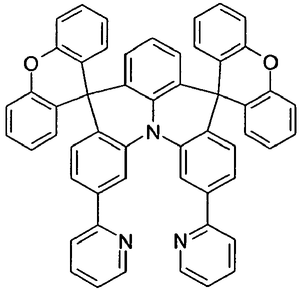

Durchführung analog Beispiel 48, wobei anstelle von 36.4 g (50 mmol) S27 38.0 g (50 mmol) S29 eingesetzt wird. Ausbeute: 20.5 g (27 mmol), 54.1 %; Reinheit: ca. 99 %ig nach ¹H-NMR.

### Synthese der Komplexe

Die Synthese der Komplexe erfolgt gemäß dem oben unter C) Variante A genannten Verfahren für die Komplexierung.

| **Bsp.** | **Ligand L** | **Pt-Komplex** | **Variante Extraktionsmittel** | **Ausbeute** |
|---|---|---|---|---|
| 114 | L27 | 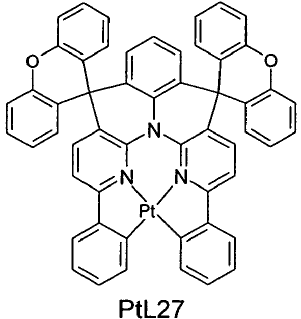 | A | 29 % |
| | | | Toluol | |
| 115 | L28 | 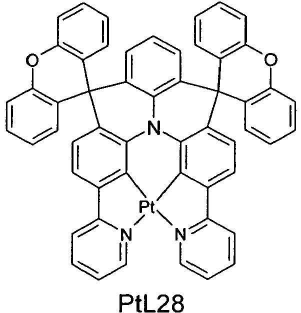 | A | 31 % |
| | | | Toluol | |

Die Herstellung der OLEDs erfolgt wie oben beschrieben. Die OLEDs weisen den fologenden Aufbau auf:

| Bsp. | HIL1 | HIL2 | HTL | EML | HBL | ETL |
|---|---|---|---|---|---|---|
| | Dicke | Dicke | Dicke | Dicke | Dicke | Dicke |
| 116 | HIM1 | HIM2 | HTM | M1:M2:PtL27 | M1 | ETM1:LiQ |
| | 70 nm | 5 nm | 90 nm | (80%:15%:5%) | 10 nm | (50%:50%) |
| | | | | 40 nm | | 30 nm |
| 117 | HIM1 | HIM2 | HTM | M3:PtL19 | ETM1 | ETM1:LiQ |
| | 80 nm | 10 nm | 20 nm | (93%:7%) | 5 nm | (50%:50%) |
| | | | | 40 nm | | 25 nm |

Mit diesen OLEDs werden die folgenden Ergebnisse erhalten:

| Bsp. | EQE[%] bei 1000 cd/m² | Spannung (V) bei 1000 cd/m2 | CIE x/y bei 1000 cd/m² | LD50 (h) bei 1000 cd/m² |
|---|---|---|---|---|
| 116 | 16.9 | 3.9 | 0.34/0.62 | 38000 |
| 117 | 15.2 | 4.4 | 0.67/0.33 | 48000 |

## Patentansprüche

1. Verbindung gemäß Formel (1), 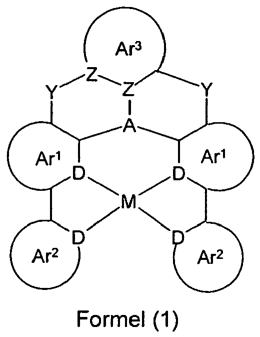 wobei für die verwendeten Symbole gilt:
M ist ein Übergangsmetall;
A ist N, P, B, C⁻ oder CR;
Y ist bei jedem Auftreten gleich oder verschieden CR₂, NR, O, S oder eine Einfachbindung, wobei maximal eine Gruppe Y für eine Einfachbindung steht;
Z ist bei jedem Auftreten gleich oder verschieden C oder N, mit der Maßgabe, dass beide Z für C stehen, wenn Ar³ für einen aromatischen oder heteroaromatischen Sechsring steht, und dass entweder beide Z für C stehen oder dass ein Z für C steht und das andere Z für N steht, wenn Ar³ für einen heteroaromatischen Fünfring steht;
D ist bei jedem Auftreten gleich oder verschieden C oder N;
Ar¹ ist bei jedem Auftreten gleich oder verschieden zusammen mit der Gruppe D und den drei explizit eingezeichneten Kohlenstoffatomen eine Aryl- oder Heteroarylgruppe mit 5 bis 13 aromatischen Ringatomen, die durch einen oder mehrere Reste R¹ substituiert sein kann;
Ar² ist bei jedem Auftreten gleich oder verschieden zusammen mit der Gruppe D und dem explizit eingezeichneten Kohlenstoffatom eine Aryl- oder Heteroarylgruppe mit 5 bis 13 aromatischen Ringatomen, die durch einen oder mehrere Reste R¹ substituiert sein kann;
Ar³ ist zusammen mit den beiden Gruppen Z und dem Kohlenstoffatom eine Aryl- oder Heteroarylgruppe mit 5 bis 10 aromatischen Ringatomen, die durch einen oder mehrere Resten R¹ substituiert sein kann;
R, R¹ ist bei jedem Auftreten gleich oder verschieden H, D, F, Cl, Br, I, N(R²)₂, CN, NO₂, OH, COOH, C(=O)N(R²)₂, Si(R²)₃, B(OR²)₂, C(=O)R², P(=O)(R²)₂, S(=O)R², S(=O)₂R², OSO₂R², eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten R² substituiert sein kann, wobei eine oder mehrere nicht benachbarte CH₂-Gruppen durch R²C=CR², C=C, Si(R²)₂, C=O, NR², O, S oder CONR² ersetzt sein können und wobei ein oder mehrere H-Atome durch D, F, Cl, Br, I oder CN ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 40 aromatischen Ringatomen, die durch einen oder mehrere Reste R² substituiert sein kann, oder eine Aralkyl- oder Heteroaralkylgruppe mit 5 bis 40 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann; dabei können zwei benachbarte Reste R oder zwei benachbarte Reste R¹ auch miteinander ein mono- oder polycyclisches, aliphatisches oder aromatisches Ringsystem bilden; weiterhin können auch die Reste R¹, die an benachbarte Gruppen Ar¹ und Ar² binden, miteinander ein mono- oder polycyclisches, aliphatisches oder aromatisches Ringsystem bilden;
R² ist bei jedem Auftreten gleich oder verschieden H, D, F, Cl, Br, I, N(R³)₂, CN, NO₂, Si(R³)₃, B(OR³)₂, C(=O)R³, P(=O)(R³)₂, S(=O)R³, S(=O)₂R³, OSO₂R³, eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten R³ substituiert sein kann, wobei eine oder mehrere nicht benachbarte CH₂-Gruppen durch R³C=CR³, C=C, Si(R³)₂, C=O, NR³, O, S oder CONR³ ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 40 aromatischen Ringatomen, die durch einen oder mehrere Reste R³ substituiert sein kann, oder eine Aralkyl- oder Heteroaralkylgruppe mit 5 bis 40 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann; dabei können zwei oder mehrere benachbarte Reste R³ miteinander ein mono- oder polycyclisches, aliphatisches Ringsystem bilden;
R³ ist bei jedem Auftreten gleich oder verschieden H, D, F oder ein aliphatischer, aromatischer und/oder heteroaromatischer Kohlenwasserstoffrest mit 1 bis 20 C-Atomen, in dem auch ein oder mehrere H-Atome durch F ersetzt sein können; dabei können zwei oder mehrere Substituenten R³ auch miteinander ein mono- oder polycyclisches, aliphatisches Ringsystem bilden.

2. Verbindung nach Anspruch 1, **dadurch gekennzeichnet, dass** M ausgewählt ist aus der Gruppe bestehend aus Platin, Palladium, Nickel, Rhodium, Iridium und Gold.

3. Verbindung nach Anspruch 1 oder 2, **dadurch gekennzeichnet, dass** zwei Gruppen D für N und die anderen beiden Gruppen D für C stehen.

4. Verbindung nach einem oder mehreren der Ansprüche 1 bis 3,
**dadurch gekennzeichnet, dass** Y gleich oder verschieden bei jedem Auftreten für CR₂ oder für eine Einfachbindung steht, wobei maximal eine Gruppe Y für eine Einfachbindung steht.

5. Verbindung nach einem oder mehreren der Ansprüche 1 bis 4,
**dadurch gekennzeichnet, dass** beide Brücken Y gleich gewählt sind.

6. Verbindung nach einem oder mehreren der Ansprüche 1 bis 5 gemäß Formel (2), 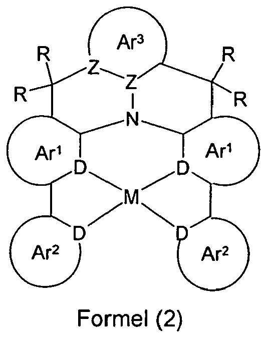 wobei die verwendeten Symbole die in Anspruch 1 genannten Bedeutungen aufweisen.

7. Verbindung nach einem oder mehreren der Ansprüche 1 bis 6, **dadurch gekennzeichnet, dass** Ar³ ausgewählt ist aus den Strukturen der Formeln (3), (4) und (5), 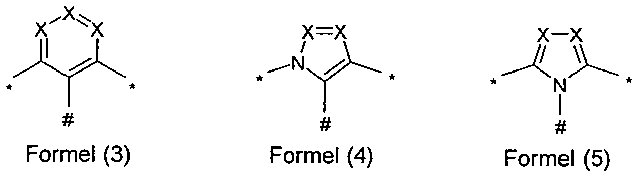 wobei X gleich oder verschieden bei jedem Auftreten für CR¹ oder N steht oder wobei zwei benachbarte Gruppen X in Formel (3) zusammen für NR, O oder S stehen und die andere Gruppe X für CR¹ oder N steht; * deutet die Bindung an Y an, und # deutet die Bindung an A an.

8. Verbindung nach einem oder mehreren der Ansprüche 1 bis 7,
**dadurch gekennzeichnet, dass** Ar¹ gleich oder verschieden bei jedem Auftreten ausgewählt ist aus den Strukturen der Formeln (6) bis (16), 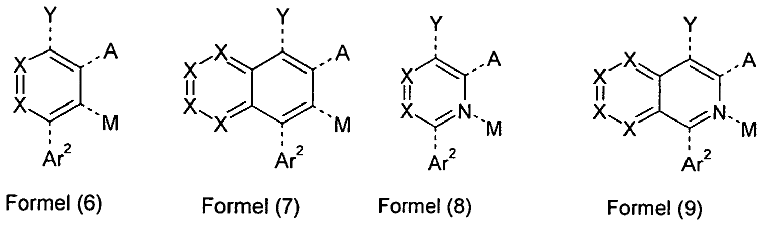 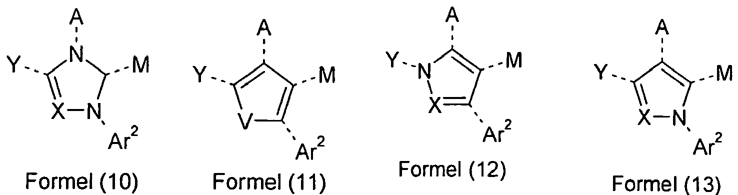 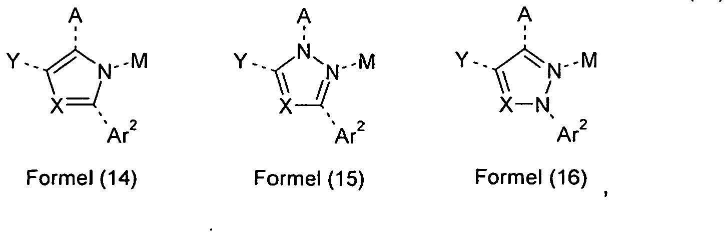 wobei durch die gestrichelte Bindungen jeweils die Bindung an A, Y, M und Ar² angedeutet ist, X bei jedem Auftreten gleich oder verschieden für CR¹ oder N steht, V steht bei jedem Auftreten gleich oder verschieden für O, S oder NR¹ steht und R dieselbe Bedeutung hat, wie in Anspruch 1 beschrieben.

9. Verbindung nach einem oder mehreren der Ansprüche 1 bis 8,
**dadurch gekennzeichnet, dass** Ar² gleich oder verschieden bei jedem Auftreten ausgewählt ist aus den Strukturen der Formeln (17) bis (38), 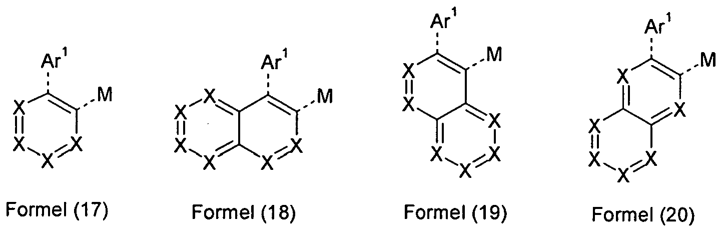 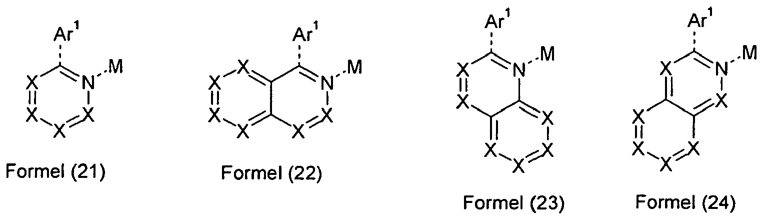 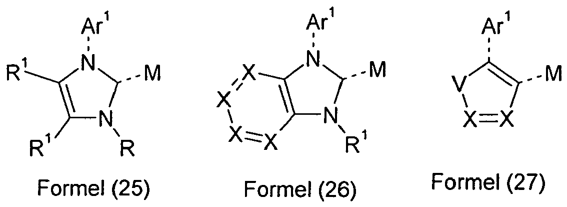 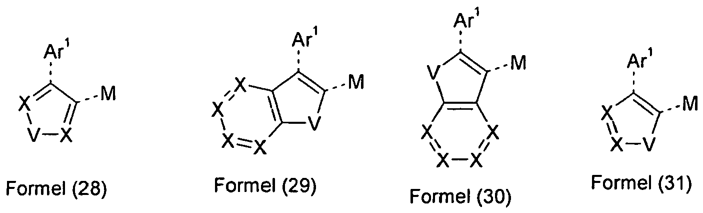 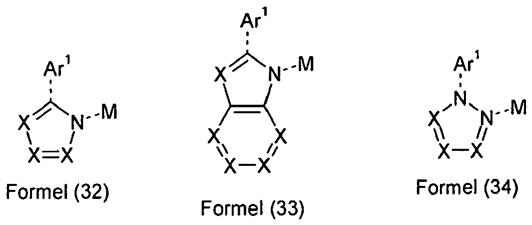 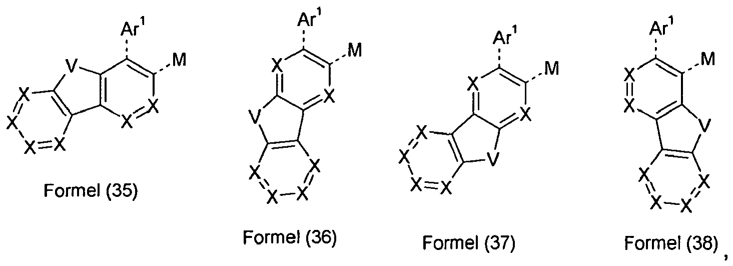 wobei durch die gestrichelte Bindungen jeweils die Bindung an A, Y, M und Ar¹ angedeutet ist, X bei jedem Auftreten gleich oder verschieden für CR¹ oder N steht, V steht bei jedem Auftreten gleich oder verschieden für O, S oder NR¹ steht und R dieselbe Bedeutung hat, wie in Anspruch 1 beschrieben.

10. Verbindung nach einem oder mehreren der Ansprüche 1 bis 9,
**dadurch gekennzeichnet, dass** R¹ bei jedem Auftreten gleich oder verschieden ausgewählt ist aus der Gruppe bestehend aus H, D, F, Br, I, N(R²)₂, CN, Si(R²)₃, B(OR²)₂, C(=O)R², einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, die jeweils mit einem oder mehreren Resten R² substituiert sein kann, wobei ein oder mehrere H-Atome durch D oder F ersetzt sein können, oder einem aromatischen oder heteroaromatischen Ringsystem mit 5 bis 30 aromatischen Ringatomen, das jeweils durch einen oder mehrere Reste R² substituiert sein kann; dabei können zwei benachbarte Reste R¹ oder zwei Reste R¹ an benachbarten Gruppen Ar¹ und Ar² auch miteinander ein mono- oder polycyclisches, aliphatisches Ringsystem bilden.

11. Verbindung nach einem oder mehreren der Ansprüche 1 bis 10,
**dadurch gekennzeichnet, dass**, wenn Y für NR steht, R gleich oder verschieden bei jedem Auftreten für ein aromatisches oder heteroaromatisches Ringsystem mit 5 bis 18 aromatischen Ringatomen steht, das jeweils durch einen oder mehrere Reste R² substituiert sein kann, und dass, wenn Y für CR₂ steht, R gleich oder verschieden bei jedem Auftreten für H, D, eine geradkettige Alkylgruppe mit 1 bis 10 C-Atomen oder eine Alkenyl- oder Alkinylgruppe mit 2 bis 10 C-Atomen oder eine verzweigte oder cyclische Alkylgruppe mit 3 bis 10 C-Atomen, die jeweils mit einem oder mehreren Resten R² substituiert sein kann, wobei ein oder mehrere H-Atome durch D oder F ersetzt sein können, oder ein aromatisches oder heteroaromatisches Ringsystem mit 5 bis 18 aromatischen Ringatomen, das jeweils durch einen oder mehrere Reste R² substituiert sein kann, steht; dabei können zwei oder mehrere Reste R, welche an dasselbe Kohlenstoffatom binden, auch miteinander ein mono- oder polycyclisches, aliphatisches oder aromatisches Ringsystem bilden.

12. Verbindung nach einem oder mehreren der Ansprüche 1 bis 11,
**dadurch gekennzeichnet, dass** gilt:
M ist ausgewählt aus der Gruppe bestehend aus Pt(II), Pd(II), Ni(II), Rh(I), Ir(I) und Au(III);
D ist bei jedem Auftreten gleich oder verschieden C oder N, wobei zwei Gruppen D für N stehen und die anderen beiden Gruppen D für C stehen;
A ist N oder P;
Y ist gleich oder verschieden bei jedem Auftreten CR₂ oder eine Einfachbindung, wobei maximal eine Gruppe Y für eine Einfachbindung steht;
Ar³ ist ausgewählt aus den oben genannten Strukturen der Formeln (3), (4) oder (5) gemäß Anspruch 7;
Ar¹ ist ausgewählt aus den oben genannten Strukturen der Formeln (6) bis (16) gemäß Anspruch 8;
Ar² ist ausgewählt aus den oben genannten Strukturen der Formeln (17) bis (38) gemäß Anspruch 9;
R¹ ist bei jedem Auftreten gleich oder verschieden ausgewählt aus der Gruppe bestehend aus H, D, F, Br, I, N(R²)₂, CN, Si(R²)₃, B(OR²)₂, C(=O)R², einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, die jeweils mit einem oder mehreren Resten R² substituiert sein kann, wobei ein oder mehrere H-Atome durch D oder F ersetzt sein können, oder einem aromatischen oder heteroaromatischen Ringsystem mit 5 bis 30 aromatischen Ringatomen, das jeweils durch einen oder mehrere Reste R² substituiert sein kann; dabei können zwei benachbarte Reste R¹ oder zwei Reste R¹ an benachbarten Gruppen Ar¹ und Ar² auch miteinander ein mono- oder polycyclisches, aliphatisches Ringsystem bilden;
R ist für Y = NR gleich oder verschieden bei jedem Auftreten ein aromatisches oder heteroaromatisches Ringsystem mit 5 bis 18 aromatischen Ringatomen, das jeweils durch einen oder mehrere Reste R² substituiert sein kann; und ist für Y = CR₂ gleich oder verschieden H, D, eine geradkettige Alkylgruppe mit 1 bis 10 C-Atomen oder eine Alkenyl- oder Alkinylgruppe mit 2 bis 10 C-Atomen oder eine verzweigte oder cyclische Alkylgruppe mit 3 bis 10 C-Atomen, die jeweils mit einem oder mehreren Resten R² substituiert sein kann, wobei ein oder mehrere H-Atome durch D oder F ersetzt sein können, oder ein aromatisches oder heteroaromatisches Ringsystem mit 5 bis 18 aromatischen Ringatomen, das jeweils durch einen oder mehrere Reste R² substituiert sein kann und das bevorzugt keine kondensierten Aryl- oder Heteroarylgruppen enthält; dabei können zwei oder mehrere Reste R, welche an dasselbe Kohlenstoffatom binden, auch miteinander ein mono- oder polycyclisches, aliphatisches oder aromatisches Ringsystem bilden.

13. Verfahren zur Herstellung einer Verbindung nach einem oder mehreren der Ansprüche 1 bis 12 durch Umsetzung des freien Liganden mit einer Metallverbindung.

14. Formulierung, insbesondere eine Lösung, eine Suspension oder eine Miniemulsion, enthaltend mindestens eine Verbindung nach einem oder mehreren der Ansprüche 1 bis 12 und mindestens ein Lösemittel, oder eine Mischung, enthaltend mindestens eine Verbindung nach einem oder mehreren der Ansprüche 1 bis 12 und mindestens eine weitere Verbindung.

15. Verwendung einer Verbindung nach einem oder mehreren der Ansprüche 1 bis 12 in einer elektronischen Vorrichtung, insbesondere in einer organischen Elektrolumineszenzvorrichtung, einer organischen integrierten Schaltung, einem organischen Feld-Effekt-Transistor, einem organischen Dünnfilmtransistor, einem organischen lichtemittierenden Transistor, einer organischen Solarzelle, einem organischen optischen Detektor, einem organischen Photorezeptor, einem organischen Feld-Quench-Device, einer lichtemittierenden elektrochemischen Zelle oder einer organischen Laserdiode.

16. Elektronische Vorrichtung, insbesondere organische Elektrolumineszenzvorrichtung, organische integrierte Schaltung, organischer Feld-Effekt-Transistor, organischer Dünnfilmtransistor, organischer lichtemittierenden Transistor, organische Solarzelle, organischer optischer Detektor, organischer Photorezeptor, organisches Feld-Quench-Device, lichtemittierende elektrochemische Zelle oder organische Laserdiode, enthaltend mindestens eine Verbindung nach einem oder mehreren der Ansprüche 1 bis 12.

17. Elektronische Vorrichtung nach Anspruch 16, wobei es sich um eine organische Elektrolumineszenzvorrichtung handelt, **dadurch gekennzeichnet, dass** die Verbindung nach einem oder mehreren der Ansprüche 1 bis 12 als emittierende Verbindung in einer oder mehreren emittierenden Schichten eingesetzt wird, bevorzugt in Kombination mit einem oder mehreren Matrixmaterialien.

## Claims

1. Compound of the formula (1), 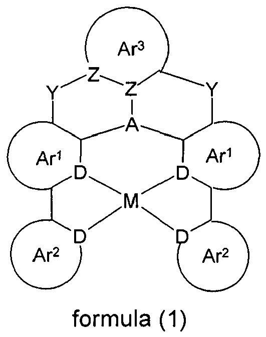 where the following applies to the symbols used:
M is a transition metal;
A is N, P, B, C⁻ or CR;
Y is on each occurrence, identically or differently, CR₂, NR, O, S or a single bond, where a maximum of one group Y stands for a single bond;
Z is on each occurrence, identically or differently, C or N, with the proviso that both Z stand for C if Ar³ stands for an aromatic or heteroaromatic six-membered ring, and that either both Z stand for C or one Z stands for C and the other Z stands for N if Ar³ stands for a heteroaromatic five-membered ring;
D is on each occurrence, identically or differently, C or N;
Ar¹ is on each occurrence, identically or differently, together with the group D and the three carbon atoms explicitly drawn in, an aryl or heteroaryl group having 5 to 13 aromatic ring atoms, which may be substituted by one or more radicals R¹;
Ar² is on each occurrence, identically or differently, together with the group D and the carbon atom explicitly drawn in, an aryl or heteroaryl group having 5 to 13 aromatic ring atoms, which may be substituted by one or more radicals R¹;
Ar³ is, together with the two groups Z and the carbon atom, an aryl or heteroaryl group having 5 to 10 aromatic ring atoms, which may be substituted by one or more radicals R¹;
R, R¹ are on each occurrence, identically or differently, H, D, F, Cl, Br, I, N(R²)₂, CN, NO₂, OH, COOH, C(=O)N(R²)₂, Si(R²)₃, B(OR²)₂, C(=O)R², P(=O)(R²)₂, S(=O)R², S(=O)₂R², OSO₂R², a straight-chain alkyl, alkoxy or thioalkoxy group having 1 to 20 C atoms or an alkenyl or alkynyl group having 2 to 20 C atoms or a branched or cyclic alkyl, alkoxy or thioalkoxy group having 3 to 20 C atoms, each of which may be substituted by one or more radicals R², where one or more non-adjacent CH₂ groups may be replaced by R²C=CR², C=C, Si(R²)₂, C=O, NR², O, S or CONR² and where one or more H atoms may be replaced by D, F, Cl, Br, I or CN, or an aromatic or heteroaromatic ring system having 5 to 60 aromatic ring atoms, which may in each case be substituted by one or more radicals R², or an aryloxy or heteroaryloxy group having 5 to 40 aromatic ring atoms, which may be substituted by one or more radicals R², or an aralkyl or heteroaralkyl group having 5 to 40 aromatic ring atoms, which may be substituted by one or more radicals R², or a diarylamino group, diheteroarylamino group or arylheteroarylamino group having 10 to 40 aromatic ring atoms, which may be substituted by one or more radicals R²; two adjacent radicals R or two adjacent radicals R¹ here may also form a mono- or polycyclic, aliphatic or aromatic ring system with one another; furthermore, the radicals R¹ which are bonded to adjacent groups Ar¹ and Ar² may also form a mono- or polycyclic, aliphatic or aromatic ring system with one another;
R² is on each occurrence, identically or differently, H, D, F, Cl, Br, I, N(R³)₂, CN, NO₂, Si(R³)₃, B(OR³)₂, C(=O)R³, P(=O)(R³)₂, S(=O)R³, S(=O)₂R³, OSO₂R³, a straight-chain alkyl, alkoxy or thioalkoxy group having 1 to 20 C atoms or an alkenyl or alkynyl group having 2 to 20 C atoms or a branched or cyclic alkyl, alkoxy or thioalkoxy group having 3 to 20 C atoms, each of which may be substituted by one or more radicals R³, where one or more non-adjacent CH₂ groups may be replaced by R³C=CR³, C=C, Si(R³)₂, C=O, NR³, O, S or CONR³ and where one or more H atoms may be replaced by D, F, Cl, Br, I, CN or NO₂, or an aromatic or heteroaromatic ring system having 5 to 60 aromatic ring atoms, which may in each case be substituted by one or more radicals R³, or an aryloxy or heteroaryloxy group having 5 to 40 aromatic ring atoms, which may be substituted by one or more radicals R³, or an aralkyl or heteroaralkyl group having 5 to 40 aromatic ring atoms, which may be substituted by one or more radicals R³, or a diarylamino group, diheteroarylamino group or arylheteroarylamino group having 10 to 40 aromatic ring atoms, which may be substituted by one or more radicals R³; two or more adjacent radicals R³ here may form a mono- or polycyclic, aliphatic ring system with one another;
R³ is on each occurrence, identically or differently, H, D, F or an aliphatic, aromatic and/or heteroaromatic hydrocarbon radical having 1 to 20 C atoms, in which, in addition, one or more H atoms may be replaced by F; two or more substituents R³ here may also form a mono- or polycyclic, aliphatic ring system with one another.

2. Compound according to Claim 1, **characterised in that** M is selected from the group consisting of platinum, palladium, nickel, rhodium, iridium and gold.

3. Compound according to Claim 1 or 2, **characterised in that** two groups D stand for N and the other two groups D stand for C.

4. Compound according to one or more of Claims 1 to 3, **characterised in that** Y stands, identically or differently on each occurrence, for CR₂ or for a single bond, where a maximum of one group Y stands for a single bond.

5. Compound according to one or more of Claims 1 to 4, **characterised in that** the two bridges Y are selected identically.

6. Compound according to one or more of Claims 1 to 5 of the formula (2), 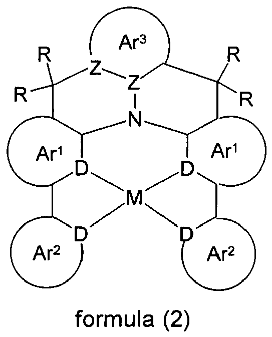 where the symbols used have the meanings given in Claim 1.

7. Compound according to one or more of Claims 1 to 6, **characterised in that** Ar³ is selected from the structures of the formulae (3), (4) and (5), 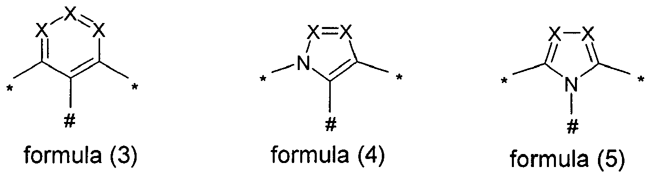 where X stands, identically or differently on each occurrence, for CR¹ or N or where two adjacent groups X in formula (3) together stand for NR, O or S and the other group X stands for CR¹ or N; * indicates the bond to Y, and # indicates the bond to A.

8. Compound according to one or more of Claims 1 to 7, **characterised in that** Ar¹ is selected, identically or differently on each occurrence, from the structures of the formulae (6) to (16), 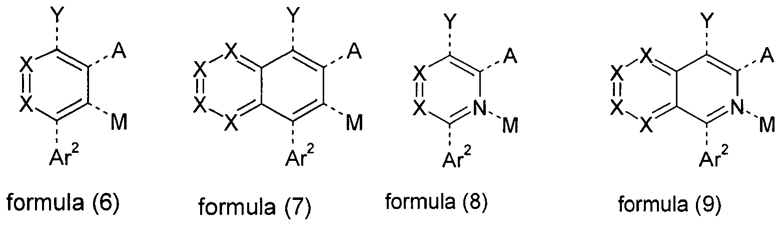 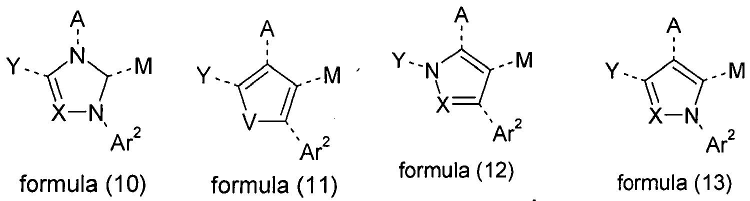 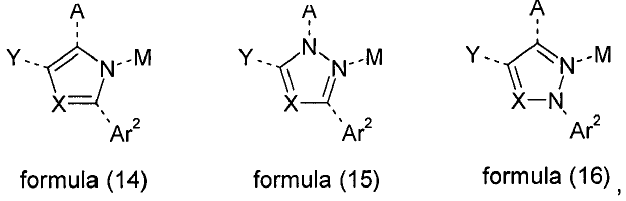 where the bond to A, Y, M and Ar² is in each case indicated by the dashed bonds, X stands on each occurrence, identically or differently, for CR¹ or N, V stands on each occurrence, identically or differently, for O, S or NR¹ and R has the same meaning as described in Claim 1.

9. Compound according to one or more of Claims 1 to 8, **characterised in that** Ar² is selected, identically or differently on each occurrence, from the structures of the formulae (17) to (38), 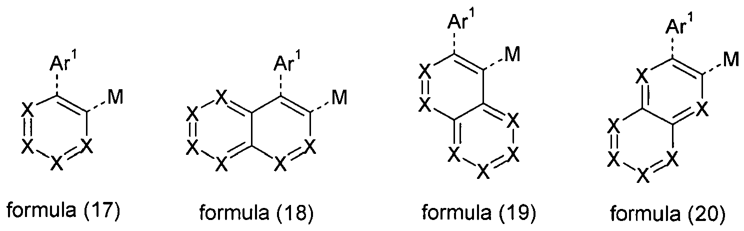 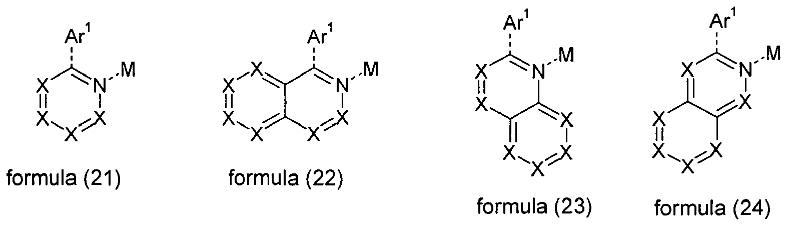 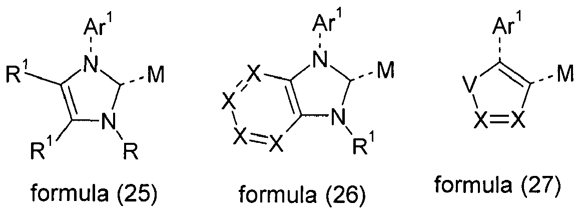 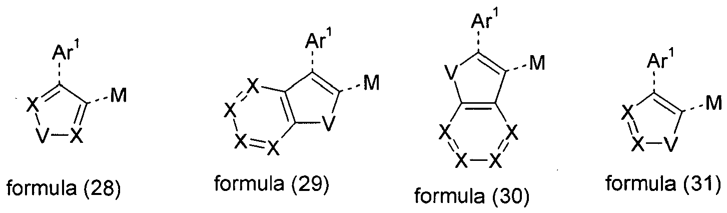 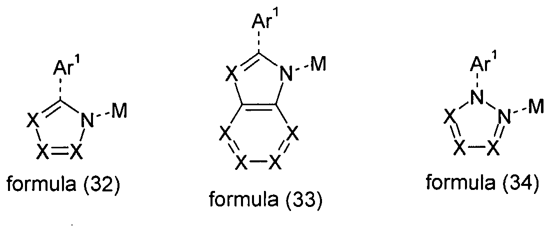 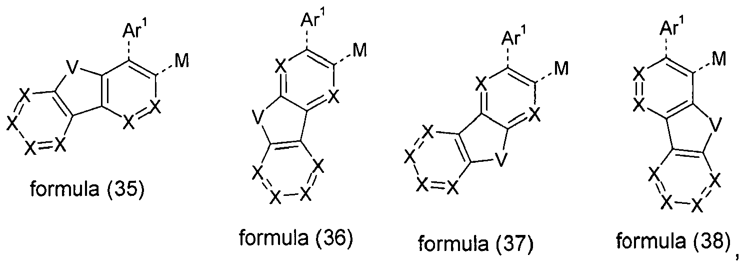 where the bond to A, Y, M and Ar¹ is in each case indicated by the dashed bonds, X stands on each occurrence, identically or differently, for CR¹ or N, V stands on each occurrence, identically or differently, for O, S or NR¹ and R has the same meaning as described in Claim 1.

10. Compound according to one or more of Claims 1 to 9, **characterised in that** R¹ is selected on each occurrence, identically or differently, from the group consisting of H, D, F, Br, I, N(R²)₂, CN, Si(R²)₃, B(OR²)₂, C(=O)R², a straight-chain alkyl group having 1 to 10 C atoms or an alkenyl group having 2 to 10 C atoms or a branched or cyclic alkyl group having 3 to 10 C atoms, each of which may be substituted by one or more radicals R², where one or more H atoms may be replaced by D or F, or an aromatic or heteroaromatic ring system having 5 to 30 aromatic ring atoms, which may in each case be substituted by one or more radicals R²; two adjacent radicals R¹ or two radicals R¹ on adjacent groups Ar¹ and Ar² here may also form a mono- or polycyclic, aliphatic ring system with one another.

11. Compound according to one or more of Claims 1 to 10, **characterised in that**, if Y stands for NR, R stands, identically or differently on each occurrence, for an aromatic or heteroaromatic ring system having 5 to 18 aromatic ring atoms, which may in each case be substituted by one or more radicals R², and **in that**, if Y stands for CR₂, R stands, identically or differently on each occurrence, for H, D, a straight-chain alkyl group having 1 to 10 C atoms or an alkenyl or alkynyl group having 2 to 10 C atoms or a branched or cyclic alkyl group having 3 to 10 C atoms, each of which may be substituted by one or more radicals R², where one or more H atoms may be replaced by D or F, on or aromatic or heteroaromatic ring system having 5 to 18 aromatic ring atoms, which may in each case be substituted by one or more radicals R²; two or more radicals R which are bonded to the same carbon atom here may also form a mono- or polycyclic, aliphatic or aromatic ring system with one another..

12. Compound according to one or more of Claims 1 to 11, **characterised in that**:
M is selected from the group consisting of Pt(II), Pd(II), Ni(II), Rh(I), Ir(I) and Au(III);
D is on each occurrence, identically or differently, C or N, where two groups D stand for N and the other two groups D stand for C;
A is N or P;
Y is, identically or differently on each occurrence, CR₂ or a single bond, where a maximum of one group Y stands for a single bond;
Ar³ is selected from the above-mentioned structures of the formulae (3), (4) or (5) according to Claim 7;
Ar¹ is selected from the above-mentioned structures of the formulae (6) to (16) according to Claim 8;
Ar² is selected from the above-mentioned structures of the formulae (17) to (38) according to Claim 9;
R¹ is selected on each occurrence, identically or differently, from the group consisting of H, D, F, Br, I, N(R²)₂, CN, Si(R²)₃, B(OR²)₂, C(=O)R², a straight-chain alkyl group having 1 to 10 C atoms or an alkenyl group having 2 to 10 C atoms or a branched or cyclic alkyl group having 3 to 10 C atoms, each of which may be substituted by one or more radicals R², where one or more H atoms may be replaced by D or F, or an aromatic or heteroaromatic ring system having 5 to 30 aromatic ring atoms, which may in each case be substituted by one or more radicals R²; two adjacent radicals R¹ or two radicals R¹ on adjacent groups Ar¹ and Ar² here may also form a mono- or polycyclic, aliphatic ring system with one another;
R is, for Y = NR, identically or differently on each occurrence, an aromatic or heteroaromatic ring system having 5 to 18 aromatic ring atoms, which may in each case be substituted by one or more radicals R²; and is, for Y = CR₂, identically or differently, H, D, a straight-chain alkyl group having 1 to 10 C atoms or an alkenyl or alkynyl group having 2 to 10 C atoms or a branched or cyclic alkyl group having 3 to 10 C atoms, each of which may be substituted by one or more radicals R², where one or more H atoms may be replaced by D or F, or an aromatic or heteroaromatic ring system having 5 to 18 aromatic ring atoms, which may in each case be substituted by one or more radicals R² and which preferably contains no condensed aryl or heteroaryl groups; two or more radicals R which are bonded to the same carbon atom here may also form a mono- or polycyclic, aliphatic or aromatic ring system with one another.

13. Process for the preparation of a compound according to one or more of Claims 1 to 12 by reaction of the free ligand with a metal compound.

14. Formulation, in particular a solution, a suspension or a mini-emulsion, comprising at least one compound according to one or more of Claims 1 to 12 and at least one solvent, or a mixture comprising at least one compound according to one or more of Claims 1 to 12 and at least one further compound.

15. Use of a compound according to one or more of Claims 1 to 12 in an electronic device, in particular in an organic electroluminescent device, an organic integrated circuit, an organic field-effect transistor, an organic thin-film transistor, an organic light-emitting transistor, an organic solar cell, an organic optical detector, an organic photoreceptor, an organic field-quench device, a light-emitting electrochemical cell or an organic laser diode.

16. Electronic device, in particular organic electroluminescent device, organic integrated circuit, organic field-effect transistor, organic thin-film transistor, organic light-emitting transistor, organic solar cell, organic optical detector, organic photoreceptor, organic field-quench device, light-emitting electrochemical cell or organic laser diode, comprising at least one compound according to one or more of Claims 1 to 12.

17. Electronic device according to Claim 16, which is an organic electroluminescent device, **characterised in that** the compound according to one or more of Claims 1 to 12 is employed as emitting compound in one or more emitting layers, preferably in combination with one or more matrix materials.

## Revendications

1. Composé de la formule (1), 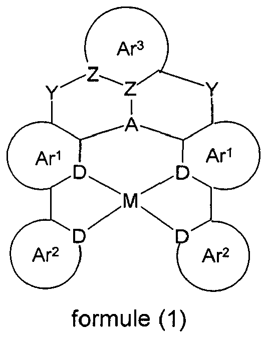 où ce qui suit s'applique aux symboles utilisés :
M est un métal de transition ;
A est N, P, B, C- ou CR ;
Y est, pour chaque occurrence, de manière identique ou différente, CR₂, NR, O, S ou une liaison simple, où un maximum d'un groupe Y représente une liaison simple ;
Z est, pour chaque occurrence, de manière identique ou différente, C ou N, étant entendu que les deux Z représentent C si Ar³ représente un cycle aromatique ou hétéroaromatique à six éléments, et que soit les deux Z représentent C, soit un Z représente C et l'autre Z représente N si Ar³ représente un cycle hétéroaromatique à cinq éléments ;
D est, pour chaque occurrence, de manière identique ou différente, C ou N ;
Ar¹ est, pour chaque occurrence, de manière identique ou différente, en association avec le groupe D et les trois atomes de carbone explicitement impliqués, un groupe aryle ou hétéroaryle comportant de 5 à 13 atomes de cycle aromatique, lequel peut être substitué par un radical ou plusieurs radicaux R¹ ;
Ar² est, pour chaque occurrence, de manière identique ou différente, en association avec le groupe D et l'atome de carbone explicitement impliqué, un groupe aryle ou hétéroaryle comportant de 5 à 13 atomes de cycle aromatique, lequel peut être substitué par un radical ou plusieurs radicaux R¹ ;
Ar³ est, en association avec les deux groupes Z et l'atome de carbone, un groupe aryle ou hétéroaryle comportant de 5 à 10 atomes de cycle aromatique, lequel peut être substitué par un radical ou plusieurs radicaux R¹ ;
R, R¹ sont, pour chaque occurrence, de manière identique ou différente, H, D, F, CI, Br, I, N(R²)₂, CN, NO₂, OH, COOH, C(=O)N(R²)₂, Si(R²)₃, B(OR²)₂, C(=O)R², P(=O)(R²)₂, S(=O)R², S(=O)₂R², OSO₂R², un groupe alkyle, alcoxy ou thioalcoxy en chaîne droite comportant de 1 à 20 atome(s) de C ou un groupe alkényle ou alkynyle comportant de 2 à 20 atomes de C ou un groupe alkyle, alcoxy ou thioalcoxy ramifié ou cyclique comportant de 3 à 20 atomes de C, dont chacun peut être substitué par un radical ou plusieurs radicaux R², où un ou plusieurs groupe(s) CH₂ non adjacents peut/peuvent être remplacé(s) par R²C=CR², C=C, Si(R²)₂, C=O, NR², O, S ou CONR² et où un ou plusieurs atome(s) de H peut/peuvent être remplacé(s) par D, F, CI, Br, I ou CN, ou un système de cycle aromatique ou hétéroaromatique comportant de 5 à 60 atomes de cycle aromatique, lequel peut dans chaque cas être substitué par un radical ou plusieurs radicaux R², ou un groupe aryloxy ou hétéroaryloxy comportant de 5 à 40 atomes de cycle aromatique, lequel peut être substitué par un radical ou plusieurs radicaux R², ou un groupe aralkyle ou hétéroaralkyle comportant de 5 à 40 atomes de cycle aromatique, lequel peut être substitué par un radical ou plusieurs radicaux R², ou un groupe diarylamino, un groupe dihétéroarylamino ou un groupe arylhétéroarylamino comportant de 10 à 40 atomes de cycle aromatique, lequel peut être substitué par un radical ou plusieurs radicaux R² ; deux radicaux R adjacents ou deux radicaux R¹ adjacents peuvent également ici former un système de cycle aliphatique ou aromatique monocyclique ou polycyclique l'un avec l'autre ; en outre, les radicaux R¹ qui sont liés à des groupes Ar¹ et Ar² adjacents peuvent également former un système de cycle aliphatique ou aromatique monocyclique ou polycyclique les uns avec les autres ;
R² est, pour chaque occurrence, de manière identique ou différente, H, D, F, CI, Br, I, N(R³)₂, CN, NO₂, Si(R³)₃, B(OR³)₂, C(=O)R³, P(=O)(R³)₂, S(=O)R³, S(=O)₂R³, OSO₂R³, un groupe alkyle, alcoxy ou thioalcoxy en chaîne droite comportant de 1 à 20 atome(s) de C ou un groupe alkényle ou alkynyle comportant de 2 à 20 atomes de C ou un groupe alkyle, alcoxy ou thioalcoxy ramifié ou cyclique comportant de 3 à 20 atomes de C, dont chacun peut être substitué par un radical ou plusieurs radicaux R³, où un groupe ou plusieurs groupes CH₂ non adjacents peut/peuvent être remplacé(s) par R³C=CR³, C=C, Si(R³)₂, C=O, NR³, O, S ou CONR³ et où un ou plusieurs atome(s) de H peut/peuvent être remplacé(s) par D, F, CI, Br, I, CN or NO₂, ou un système de cycle aromatique ou hétéroaromatique comportant de 5 à 60 atomes de cycle aromatique, lequel peut dans chaque cas être substitué par un radical ou plusieurs radicaux R³, ou un groupe aryloxy ou hétéroaryloxy comportant de 5 à 40 atomes de cycle aromatique, lequel peut être substitué par un radical ou plusieurs radicaux R³, ou un groupe aralkyle ou hétéroaralkyle comportant de 5 à 40 atomes de cycle aromatique, lequel peut être substitué par un radical ou plusieurs radicaux R³, ou un groupe diarylamino, un groupe dihétéroarylamino ou un groupe arylhétéroarylamino comportant de 10 à 40 atomes de cycle aromatique, lequel peut être substitué par un radical ou plusieurs radicaux R³ ; deux radicaux R³ adjacents ou plus peuvent ici former un système de cycle aliphatique mono-cyclique ou polycyclique l'un avec l'autre ou les uns avec les autres
R³ est, pour chaque occurrence, de manière identique ou différente, H, D, F ou un radical hydrocarbone aliphatique, aromatique et/ou hétéroaromatique comportant de 1 à 20 atome(s) de C, où, en outre, un ou plusieurs atome(s) de H peut/peuvent être remplacé(s) par F ; deux substituants R³ ou plus peuvent également ici former un système de cycle aliphatique monocyclique ou polycyclique l'un avec l'autre ou les uns avec les autres.

2. Composé selon la revendication 1, **caractérisé en ce que** M est choisi parmi le groupe constitué par platine, palladium, nickel, rhodium, iridium et or.

3. Composé selon la revendication 1 ou 2, **caractérisé en ce que** deux groupes D représentent N et les deux autres groupes D représentent C.

4. Composé selon une ou plusieurs des revendications 1 à 3, **caractérisé en ce que** Y représente, de manière identique ou différente pour chaque occurrence, CR₂ ou une liaison simple, où un maximum d'un groupe Y représente une liaison simple.

5. Composé selon une ou plusieurs des revendications 1 à 4, **caractérisé en ce que** les deux ponts Y sont choisis de manière à être identiques.

6. Composé selon une ou plusieurs des revendications 1 à 5 de la formule (2), 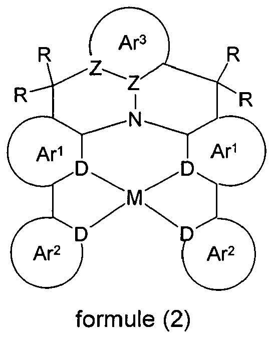 dans laquelle les symboles utilisés présentent les significations données selon la revendication 1.

7. Composé selon une ou plusieurs des revendications 1 à 6, **caractérisé en ce que** Ar³ est choisi parmi les structures des formules (3), (4) et (5), 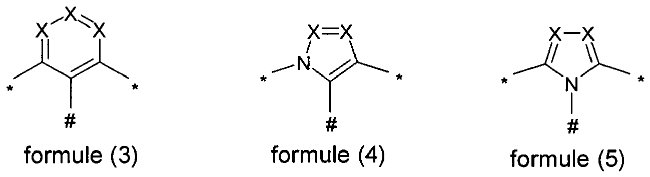 dans lesquelles X représente, de manière identique ou différente pour chaque occurrence, CR¹ ou N ou où deux groupes X adjacents dans la formule (3) représentent ensemble NR, O ou S et l'autre groupe X représente CR¹ ou N ; * indique la liaison sur Y, et # indique la liaison sur A.

8. Composé selon une ou plusieurs des revendications 1 à 7, **caractérisé en ce que** Ar¹ est choisi, de manière identique ou différente pour chaque occurrence, parmi les structures des formules (6) à (16), 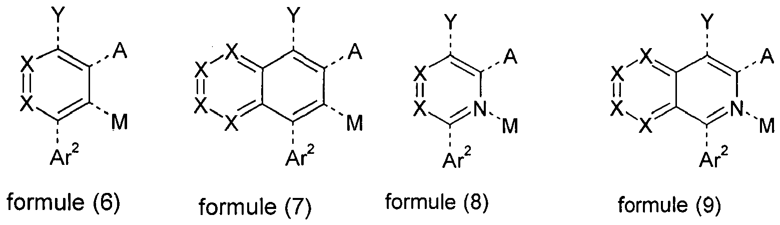 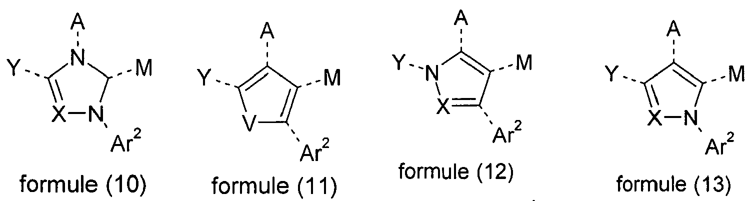 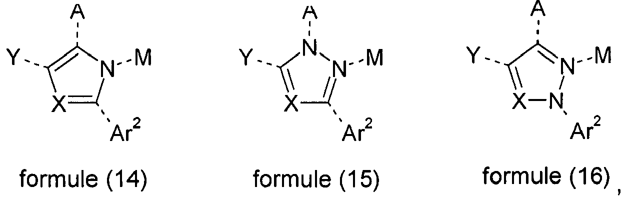 dans lesquelles la liaison sur A, Y, M et Ar² est dans chaque cas indiquée par les liaisons en pointillés, X représente pour chaque occurrence, de manière identique ou différente, CR¹ ou N, V représente pour chaque occurrence, de manière identique ou différente, O, S ou NR¹ et R présente la même signification que décrit selon la revendication 1.

9. Composé selon une ou plusieurs des revendications 1 à 8, **caractérisé en ce que** Ar² est choisi, de manière identique ou différente pour chaque occurrence, parmi les structures des formules (17) à (38), 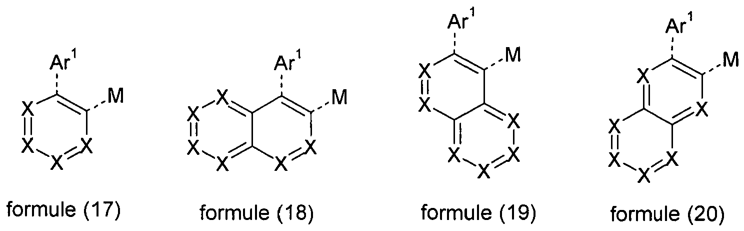 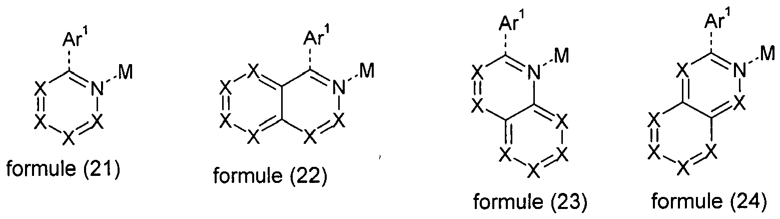 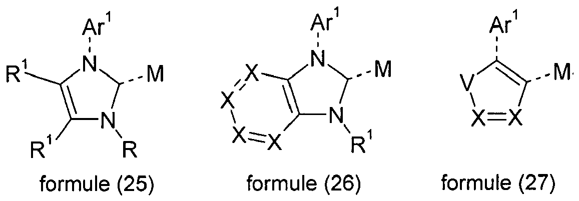 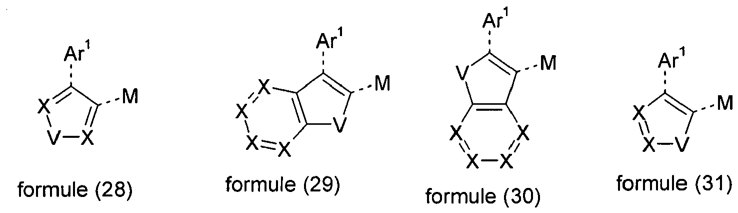 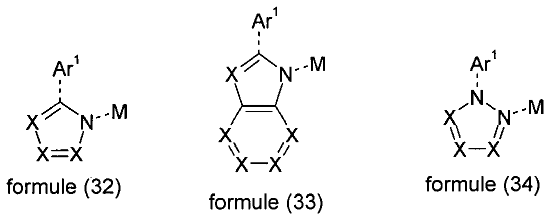 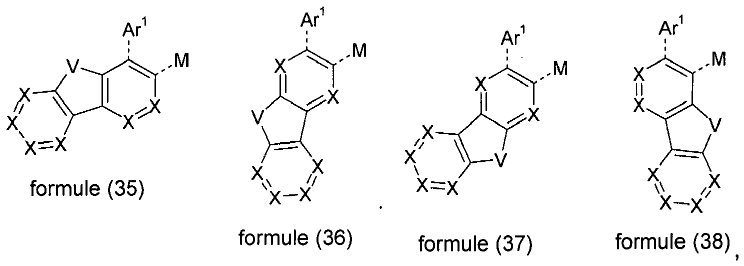 dans lesquelles la liaison sur A, Y, M et Ar¹ est dans chaque cas indiquée par les liaisons en pointillés, X représente pour chaque occurrence, de manière identique ou différente, CR¹ ou N, V représente pour chaque occurrence, de manière identique ou différente, O, S ou NR¹ et R présente la même signification que décrit selon la revendication 1.

10. Composé selon une ou plusieurs des revendications 1 à 9, **caractérisé en ce que** R¹ est choisi pour chaque occurrence, de manière identique ou différente, parmi le groupe constitué par H, D, F, Br, I, N(R²)₂, CN, Si(R²)₃, B(OR²)₂, C(=O)R², un groupe alkyle en chaîne droite comportant de 1 à 10 atome(s) de C ou un groupe alkényle comportant de 2 à 10 atomes de C ou un groupe alkyle ramifié ou cyclique comportant de 3 à 10 atomes de C, dont chacun peut être substitué par un radical ou plusieurs radicaux R², où un atome ou plusieurs atomes de H peut/ peuvent être remplacé(s) par D ou F, ou un système de cycle aromatique ou hétéroaromatique comportant de 5 à 30 atomes de cycle aromatique, lequel peut dans chaque cas être substitué par un radical ou plusieurs radicaux R² ; deux radicaux R¹ adjacents ou deux radicaux R¹ sur des groupes Ar¹ et Ar² adjacents peuvent également ici former un système de cycle aliphatique monocyclique ou polycyclique l'un avec l'autre.

11. Composé selon une ou plusieurs des revendications 1 à 10, **caractérisé en ce que**, si Y représente NR, R représente, de manière identique ou différente pour chaque occurrence, un système de cycle aromatique ou hétéroaromatique comportant de 5 à 18 atomes de cycle aromatique, lequel peut dans chaque cas être substitué par un radical ou plusieurs radicaux R², et **en ce que**, si Y représente CR₂, R représente, de manière identique ou différente pour chaque occurrence, H, D, un groupe alkyle en chaîne droite comportant de 1 à 10 atome(s) de C ou un groupe alkényle ou alkynyle comportant de 2 à 10 atomes de C ou un groupe alkyle ramifié ou cyclique comportant de 3 à 10 atomes de C, dont chacun peut être substitué par un radical ou plusieurs radicaux R², où un ou plusieurs atome(s) de H peut/peuvent être remplacé(s) par D ou F, ou un système de cycle aromatique ou hétéroaromatique comportant de 5 à 18 atomes de cycle aromatique, lequel peut dans chaque cas être substitué par un radical ou plusieurs radicaux R² ; deux radicaux R ou plus qui sont liés au même atome de carbone peuvent également ici former un système de cycle aliphatique ou aromatique monocyclique ou polycyclique l'un avec l'autre ou les uns avec les autres.

12. Composé selon une ou plusieurs des revendications 1 à 11, **caractérisé en ce que** :
M est choisi parmi le groupe constitué par Pt(II), Pd(II), Ni(II), Rh(I), Ir(I) et Au(III) ;
D est, pour chaque occurrence, de manière identique ou différente, C ou N, où deux groupes D représentent N et les deux autres groupes D représentent C ;
A est N ou P ;
Y est, de manière identique ou différente pour chaque occurrence, CR₂ ou une liaison simple, où un maximum d'un groupe Y représente une liaison simple ;
Ar³ est choisi parmi les structures mentionnées ci avant des formules (3), (4) ou (5) selon la revendication 7 ;
Ar¹ est choisi parmi les structures mentionnées ci avant des formules (6) à (16) selon la revendication 8 ;
Ar² est choisi parmi les structures mentionnées ci avant des formules (17) à (38) selon la revendication 9 ;
R¹ est choisi, pour chaque occurrence, de manière identique ou différente, parmi le groupe constitué par H, D, F, Br, I, N(R²)₂, CN, Si(R²)₃, B(OR²)₂, C(=O)R², un groupe alkyle en chaîne droite comportant de 1 à 10 atome(s) de C ou un groupe alkényle comportant de 2 à 10 atomes de C ou un groupe alkyle ramifié ou cyclique comportant de 3 à 10 atomes de C, dont chacun peut être substitué par un radical ou plusieurs radicaux R², où un ou plusieurs atome(s) de H peut/peuvent être remplacé(s) par D ou F, ou un système de cycle aromatique ou hétéroaromatique comportant de 5 à 30 atomes de cycle aromatique, lequel peut dans chaque cas être substitué par un radical ou plusieurs radicaux R² ; deux radicaux R¹ adjacents ou deux radicaux R¹ sur des groupes Ar¹ et Ar² adjacents peuvent également ici former un système de cycle aliphatique monocyclique ou polycyclique l'un avec l'autre ;
R est, pour Y = NR, de manière identique ou différente pour chaque occurrence, un système de cycle aromatique ou hétéroaromatique comportant de 5 à 18 atomes de cycles aromatique, lequel peut dans chaque cas être substitué par un radical ou plusieurs radicaux R² ; et est, pour Y = CR₂, de manière identique ou différente, H, D, un groupe alkyle en chaîne droite comportant de 1 à 10 atome(s) de C ou un groupe alkényle ou alkynyle comportant de 2 à 10 atomes de C ou un groupe alkyle ramifié ou cyclique comportant de 3 à 10 atomes de C, dont chacun peut être substitué par un radical ou plusieurs radicaux R², où un atome de H ou plus peut/peuvent être remplacé(s) par D ou F, ou un système de cycle aromatique ou hétéroaromatique comportant de 5 à 18 atomes de cycle aromatique, lequel peut dans chaque cas être substitué par un radical ou plusieurs radicaux R² et lequel ne contient de préférence pas de groupes aryle ou hétéroaryle condensés ; deux radicaux R ou plus qui sont liés au même atome de carbone peuvent également ici former un système de cycle aliphatique ou aromatique monocyclique ou polycyclique l'un avec l'autre ou les uns avec les autres.

13. Procédé pour la préparation d'un composé selon une ou plusieurs des revendications 1 à 12 par réaction du ligand libre avec un composé métallique.

14. Formulation, en particulier une solution, une suspension ou une mini-émulsion, comprenant au moins un composé selon une ou plusieurs des revendications 1 à 12 et au moins un solvant, ou un mélange comprenant au moins un composé selon une ou plusieurs des revendications 1 à 12 et au moins un autre composé.

15. Utilisation d'un composé selon une ou plusieurs des revendications 1 à 12 dans un dispositif électronique, en particulier dans un dispositif électroluminescent organique, un circuit intégré organique, un transistor à effet de champ organique, un transistor à film mince organique, un transistor à émission de lumière organique, une cellule solaire organique, un détecteur optique organique, un photorécepteur organique, un dispositif à extinction de champ organique, une cellule électrochimique à émission de lumière ou une diode laser organique.

16. Dispositif électronique, en particulier un dispositif électroluminescent organique, un circuit intégré organique, un transistor à effet de champ organique, un transistor à film mince organique, un transistor à émission de lumière organique, une cellule solaire organique, un détecteur optique organique, un photorécepteur organique, un dispositif à extinction de champ organique, une cellule électrochimique à émission de lumière ou une diode laser organique, comprenant au moins un composé selon une ou plusieurs des revendications 1 à 12.

17. Dispositif électronique selon la revendication 16, lequel est un dispositif électroluminescent organique, **caractérisé en ce que** le composé selon une ou plusieurs des revendications 1 à 12 est utilisé en tant que composé d'émission dans une ou plusieurs couche(s) d'émission, de façon préférable en combinaison avec un ou plusieurs matériau(x) de matrice.
